# EUROPÄISCHE PATENTSCHRIFT

(11) **EP 1 763 870 B1**
(45) Veröffentlichungstag und Bekanntmachung des Hinweises auf die Patenterteilung: **05.03.2014**
(21) Anmeldenummer: 05782459.1
(22) Anmeldetag: 29.08.2005
(51) Int. Cl.: G10L 19/008, H04S 3/00

(54) **ERZEUGUNG EINES CODIERTEN MULTIKANALSIGNALS UND DECODIERUNG EINES CODIERTEN MULTIKANALSIGNALS**
GENERATION OF A MULTICHANNEL ENCODED SIGNAL AND DECODING OF A MULTICHANNEL ENCODED SIGNAL
PRODUCTION D'UN SIGNAL MULTICANAL CODE, ET DECODAGE D'UN SIGNAL MULTICANAL CODE

(30) Priorität: 03.09.2004 DE 102004042819
(43) Veröffentlichungstag der Anmeldung: 21.03.2007
(73) Patentinhaber: Fraunhofer-Gesellschaft zur Förderung der angewandten Forschung e.V., 80686 München (DE)
(72) Erfinder: HERRE, Jürgen, 91054 Buckenhof (DE); SPERSCHNEIDER, Ralph, 91320 Ebermannstadt (DE); HILPERT, Johannes, 90411 Nürnberg (DE); LINZMEIER, Karsten, 91058 Erlangen (DE); POPP, Harald, 90587 Tuchenbach (DE)
(74) Vertreter: Zinkler, Franz
(86) Internationale Anmeldenummer: PCT/EP2005/009293
(87) Internationale Veröffentlichungsnummer: WO 2006/027138

(56) Entgegenhaltungen:
- EP-A- 1 376 538
- J HERRE, CH FALLER, CH ERTEL, J HILPERT, A HOELZER, C SPENGER: "MP3 Surround: Efficient and Compatible Coding of Multi Channel Audio" CONVENTION PAPER AT THE 116TH AES CONVENTION, 8. Mai 2004 (2004-05-08), Seiten 1-14, XP002350798 Berlin, Germany
- FALLER C ET AL: "Binaural Cue Coding -Part II: Schemes and Applications" IEEE TRANSACTIONS ON SPEECH AND AUDIO PROCESSING, IEEE INC. NEW YORK, US, Bd. 11, Nr. 6, 6. Oktober 2003 (2003-10-06), Seiten 520-531, XP002338415 ISSN: 1063-6676
- SCHUIJERS E G P ET AL: "ADVANCES IN PARAMETRIC CODING FOR HIGH-QUALITY AUDIO" IEEE BENELUX WORKSHOP ON MODEL BASED PROCESSING AND CODING OF AUDIO, 15. November 2002 (2002-11-15), Seiten 73-79, XP001156065
- J HERRE, P KROON, C FALLER, S GEYERSBERGER: "Spatial audio coding - an enabling technology for bitrate-efficient and compatible multichannel audio broadcasting" IBC 2004 CONFERENCE, AMSTERDAM, [Online] 9. September 2004 (2004-09-09), Seiten 1-12, XP002350799 Gefunden im Internet: URL:http://www.broadcastpapers.com/ibc2004 /IBC04FIICspatial.pdf> [gefunden am 2005-10-21]
- ISO/IEC JTC1/SC29/WG11: "Text of ISO/IEC 14496-3:2001/PDAM 1" INTERNATIONAL ORGANISATION FOR STANDARDISATION, Mai 2002 (2002-05), Seiten 6-18, XP002350800

## Beschreibung

Die vorliegende Erfindung bezieht sich auf parametrische Audio-Multikanal-Verarbeitungstechniken und insbesondere auf eine effiziente Anordnung parametrischer Seiteninformationen, wenn zur Rekonstruktion mehrere verschiedene Parametersätze zur Verfügung stehen.

Eine empfohlene Multikanal-Surround-Darstellung umfasst zusätzlich zu den beiden Stereokanälen einen Mitten- (oder Center-Kanal) C und zwei Surround-Kanäle, nämlich den Left-Surround-Kanal Ls und den Right-Surround-Kanal Rs, und außerdem gegebenenfalls einen Subwoofer-Kanal, der auch als LFE-Kanal (LFE = Low Frequency Enhancement) bezeichnet wird. Dieses Referenztonformat wird auch als 3/2-(plus LFE) Stereo und in jüngerer Zeit auch als 5.1 Multikanal bezeichnet, was bedeutet, dass es drei vordere Kanäle, zwei Surround-Kanäle und einen LFE-Kanal gibt. Allgemein werden für diese empfohlene Multikanal-Surround-Darstellung fünf oder sechs Übertragungskanäle benötigt. In einer Wiedergabeumgebung werden zumindest fünf Lautsprecher in den jeweiligen fünf unterschiedlichen Positionen benötigt, um einen optimalen sogenannten Sweet-Spot in einem bestimmten Abstand von den fünf korrekt platzierten Lautsprechern zu erhalten. Der Subwoofer ist im Hinblick auf seine Positionierung dagegen relative beliebig einsetzbar.

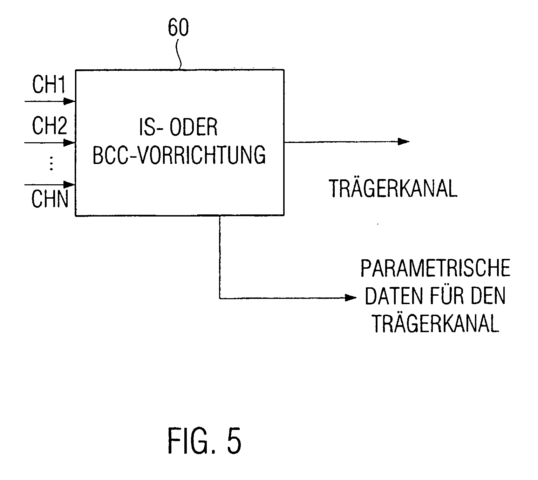

Es gibt mehrere Techniken zur Reduktion der Datenmenge, die nötig ist, um ein Multikanalaudiosignal zu übertragen. Solche Techniken werden auch Joint-Stereo-Techniken genannt. Zu diesem Zweck wird auf Fig. 5 Bezug genommen. Fig. 5 zeigt ein Joint-Stereo-Gerät 60. Dieses Gerät kann ein Gerät sein, das beispielsweise die Intensity-Stereo-Technik (IS-Technik) oder die Binaural-Cue-Codierung (BCC) implementiert. Eine solche Vorrichtung empfängt allgemein als Eingangssignal wenigstens zwei Kanäle (CH1, CH2, ...... CHn) und gibt wenigstens einen einzigen Trägerkanal (Down-mix) und parametrische Daten, also einen oder mehrere Parametersätze aus. Die parametrischen Daten sind so definiert, dass in einem Decodierer eine Approximation eines jeden ursprünglichen Kanals (CH1, CH2, ..... CHn) berechnet werden kann.

Normalerweise wird der Trägerkanal Subband-Abtastwerte, Spektralkoeffizienten oder Zeitbereichsabtastwerte, etc. umfassen, die eine vergleichsweise feine Darstellung des zugrundeliegenden Signals liefern, während die parametrischen Daten bzw. Parametersätze keine solchen Abtastwerte oder Spektralkoeffizienten umfassen. Statt dessen umfassen die parametrischen Daten Steuerparameter zum Steuern eines bestimmten Rekonstruktionsalgorithmus, wie beispielsweise Gewichten durch Multiplikation, zeitliches Verschieben, frequenzmäßiges Verschieben, ...... Die parametrischen Daten umfassen daher nur eine vergleichsweise grobe Darstellung des Signals oder des zugeordneten Kanals. In Zahlen ausgedrückt, wird die Menge an Daten, die von einem Trägerkanal benötigt wird, im Bereich von 60 bis 70 kBit/s, während die Menge an Daten, die von parametrischen Seiteninformationen benötigt wird, für einen Kanal in der Größenordnung ab 1,5 kBit/s liegen wird. Ein Beispiel für parametrische Daten sind die bekannten Skalenfaktoren, Intensity-Stereoinformationen oder Binaural-Cue-Parameter, wie es noch beschrieben wird.

Die Intensity-Stereo-Codiertechnik ist in dem AES-Preprint 3799 mit dem Titel "Intensity stereo coding" J. Herre, K. H. Brandenburg, D. Lederer, Februar 1994, Amsterdam, beschrieben. Im Allgemeinen basiert das Konzept von Intensity-Stereo auf einer Hauptachsentransformation, die auf Daten der beiden stereophonen Audiokanäle anzuwenden ist. Wenn die meisten Datenpunkte um die erste Hauptachse herum platziert sind, kann ein Codiergewinn erreicht werden, indem beide Signale um einen bestimmten Winkel vor der Codierung gedreht werden. Dies gilt jedoch nicht immer für reelle stereophone Reproduktionstechniken. Die rekonstruierten Signale für den linken und rechten Kanal bestehen aus unterschiedlich gewichteten oder skalierten Versionen desselben übertragenen Signals. Dennoch unterscheiden sich die rekonstruierten Signale in ihrer Amplitude, sind jedoch im Hinblick auf Ihre Phaseninformationen identisch. Die Energie-Zeit-Hüllkurven beider ursprünglicher Audiokanäle werden jedoch mittels der selektiven Skalieroperation beibehalten, die typischerweise auf Frequenz-selektive Art und Weise arbeitet. Dies entspricht der menschlichen Schallwahrnehmung bei hohen Frequenzen, wo die dominanten räumlichen Hinweise oder Cues durch die Energie-Hüllkurven bestimmt werden.

Zusätzlich wird bei praktischen Implementierungen das übertragene Signal, d.h. der Trägerkanal, aus dem Summensignal des linken Kanals und des rechten Kanals gebildet, anstatt dass beide Komponenten gedreht werden. Ferner wird diese Verarbeitung, d. h. das Erzeugen der Intensity-Stereo-Parameter zum Durchführen der Skalierungsoperation, frequenzselektiv durchgeführt, d. h. unabhängig voneinander für jedes Skalenfaktorband, d. h. für jede Codiererfrequenzpartition. Vorzugsweise werden beide Kanäle kombiniert, um einen kombinierten oder "Träger"-Kanal zu bilden. Zusätzlich zum kombinierten Kanal werden die Intensity-Stereo-Informationen bestimmt, die von der Energie des ersten Kanals, der Energie des zweiten Kanals und der Energie des kombinierten bzw. Summenkanals abhängen.

Die BCC-Technik ist in dem AES-Convention-Paper 5574 mit dem Titel "Binaural cue coding applied to stereo and multi-channel audio compression", C. Faller, F. Baumgarte, Mai 2002, München, beschrieben. Bei der BCC-Codierung wird eine Anzahl von Audio-Eingangskanälen in eine spektrale Darstellung unter Verwendung einer DFT-basierten Transformation mit überlappenden Fenstern umgewandelt. Das resultierende Spektrum wird in nicht-überlappende Partitionen aufgeteilt. Jede Partition hat eine Bandbreite, die proportional zu einer äquivalenten rechtwinkeligen Bandbreite (ERB) ist. So genannte Zwischenkanal-Pegeldifferenzen (ICLD = Inter-Channel Level Differences) sowie so genannte Zwischenkanal-Zeitdifferenzen (ICTD; ICTD = Interchannel Time Differences) werden für jede Partition, also für jedes Band und für jeden Frame k, also einen Block von zeitlichen Absatzwerten berechnet. Die ICLD- und ICDT-Parameter werden quantisiert und codiert, um einen BCC-Bitstrom zu erhalten. Die Zwischenkanal-Pegeldifferenzen und die Zwischenkanal-Zeitdifferenzen sind für jeden Kanal bezüglich eines Referenzkanals gegeben. Insbesondere werden die Parameter gemäß vorbestimmter Formeln berechnet, die von den bestimmten Aufteilungen des zu verarbeitenden Signals abhängen.

Auf Decodiererseite empfängt der Decodierer ein Monosignal und den BCC-Bitstrom, also einen ersten Parametersatz für die Zwischenkanal-Zeitdifferenzen und einen zweiten Parametersatz für die Zwischenkanal-Pegeldifferenzen. Das Monosignal wird in den Frequenzbereich transformiert und in einen Synthese-Block eingegeben, der ebenfalls decodierte ICLD- und ICTD-Werte empfängt. In dem Synthese-Block bzw. Rekonstruktionsblock werden die BCC-Parameter (ICLD und ICTD) verwendet, um eine Gewichtungsoperation des Monosignals durchzuführen, um das Multikanalsignal zu rekonstruieren, das dann, nach einer Frequenz/Zeit-Umwandlung eine Rekonstruktion des ursprünglichen Multikanal-Audiosignals darstellt.

Im Fall von BCC ist das Joint-Stereo-Modul 60 wirksam, um die Kanalseiteninformationen so auszugeben, dass die parametrischen Kanaldaten quantisierte und codierte ICLD- und ICTD-Parameter sind, wobei einer der ursprünglichen Kanäle als Referenzkanal zum Codieren der Kanalseiteninformationen verwendet werden kann. Normalerweise wird der Trägerkanal aus der Summe der teilnehmenden Ursprungskanäle gebildet. Natürlich liefert die obige Technik nur eine Monodarstellung für einen Decodierer, der nur den Trägerkanal decodieren kann, der jedoch nicht in der Lage ist, die Parameterdaten zum Erzeugen von einem oder mehreren Approximierungen von mehr als einem Eingangskanal zu erzeugen.

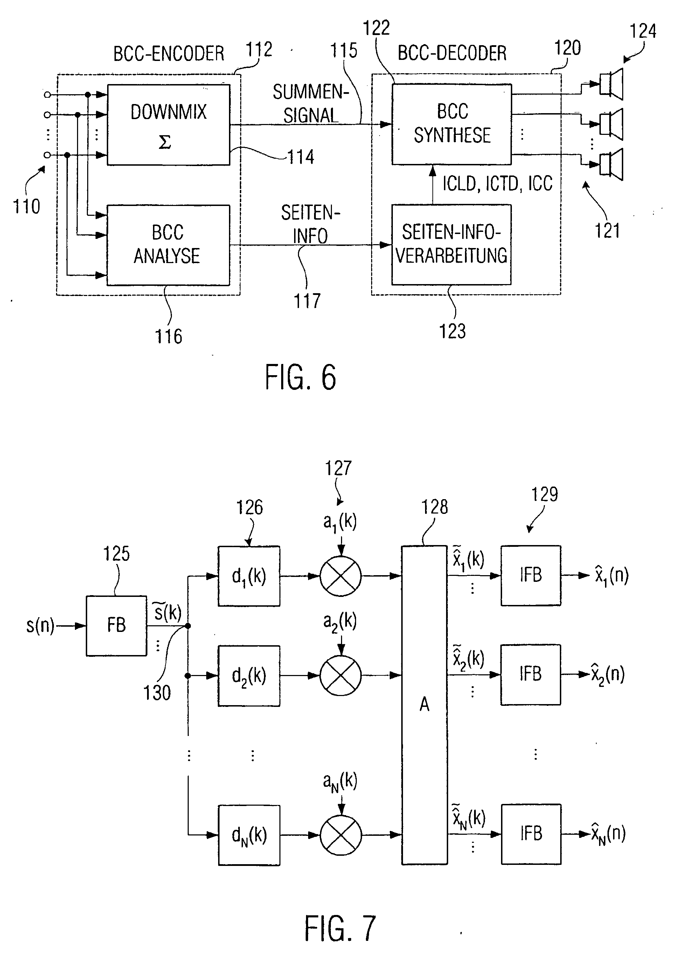

Die Audiocodiertechnik, die als BCC-Technik bezeichnet wird, ist ferner in den amerikanischen Patentanmeldungen US 2003/0219130 A1, 2003/0026441 A1 und 2003/0035553 A1 beschrieben. Zusätzlich wird ferner auf "Binaural Cue Coding. Part. II: Schemes and Applications", C. Faller und F. Baumgarte, IEEE: Transactions On Audio and Speech Proc., Bd. 11, Nr. 6, November 1993 verwiesen. Ferner wird auch auf C. Faller und F. Baumgarte "Binaural Cue Coding applied to Stereo and Multi-Channel Audio compression", Preprint, 112. Convention der Audio Engineering Society (AES), Mai 2002, sowie auf J. Herre, C. Faller, C. Ertel, J. Hilpert, A. Hoelzer, C. Spenger "MP3 Surround: Efficient and Compatible Coding of Multi-Channel Audio", 116. AES Convention, Berlin, 2004, Preprint 6049, verwiesen. Nachfolgend wird ein typisches allgemeines BCC-Schema für die Multikanalaudiocodierung detaillierter bezugnehmend auf die Fig. 6 bis 8 dargestellt. Fig. 6 zeigt ein allgemeines BCC-Codierschema zur Codierung/Übertragung von Multikanalaudiosignalen. Das Multikanalaudioeingangssignal wird an einem Eingang 110 eines BCC-Codierers 112 eingegeben und in einem sogenannten Downmix-Block 114 "herabgemischt", also in einen einzigen Summenkanal umgesetzt. Beim vorliegenden Beispiel ist das Signal an dem Eingang 110 ein 5-Kanal-Surround-Signal mit einem vorderen linken Kanal und einem vorderen rechten Kanal, einem linken Surround-Kanal und einem rechten Surround-Kanal, und einem Center-Kanal. Typischerweise erzeugt der Downmix-Block ein Summensignal durch einfache Addition dieser fünf Kanäle in ein Monosignal. Andere Downmix-Schemen sind aus der Technik bekannt, die alle dazu führen, dass unter Verwendung eines Multikanal-Eingangssignals ein Downmix-Signal mit einem einzigen Kanal oder aber mit einer Anzahl von Downmix-Kanälen erzeugt wird, die auf jeden Fall kleiner ist als die Anzahl von ursprünglichen Eingangskanälen. Beim vorliegenden Beispiel wäre bereits eine Downmix-Operation erreicht, wenn aus den fünf Eingangskanälen vier Trägerkanäle erzeugt werden würden. Der einzige Ausgangskanal bzw. die Anzahl von Ausgangskanälen wird an einer Summensignalleitung 115 ausgegeben.

Seiteninformationen, die durch einen BCC-Analyseblock 116 erhalten werden, werden an einer Seiteninformationsleitung 117 ausgegeben. Im BCC-Analyseblock können Parametersätze für ICLD, ICTD oder Zwischenkanal-Korrelationswerte (ICC-Werte; ICC = Interchannel correlation) berechnet werden. Zur Rekonstruktion im BCC-Syntheseblock 122 existieren somit bis zu drei unterschiedliche Parametersätze (ICLD, ICTD und ICC).

Das Summensignal sowie die Seiteninformationen mit den Parametersätzen werden typischerweise in einem quantisierten und codierten Format zu einem BCC-Decodierer 120 übertragen. Der BCC-Decodierer zerlegt das übertragene Summensignal in eine Anzahl von Subbändern und führt Skalierungen, Verzögerungen und weitere Verarbeitungen durch, um die Subbänder der mehreren Kanäle, die zu rekonstruieren sind, zu erzeugen. Diese Verarbeitung wird so durchgeführt, dass die ICLD-, ICTD- und ICC-Parameter (Cues) eines rekonstruierten Multikanalsignals am Ausgang 121 ähnlich zu den jeweiligen Cues für das ursprüngliche Multikanalsignal am Eingang 110 in den BCC-Codierer 112 sind. Zu diesem Zweck umfasst der BCC-Decodierer 120 einen BCC-Syntheseblock 122 und einen Seiteninformationen-Verarbeitungsblock 123.

Nachfolgend wird der interne Aufbau des BCC-Syntheseblocks 122 bezugnehmend auf Fig. 7 dargestellt. Das Summensignal auf der Leitung 115 wird in einen Zeit/Frequenz-Umwandlungsblock, der typischerweise als Filterbank FB 125 ausgeführt ist, eingegeben. Am Ausgang des Blocks 125 existiert eine Anzahl N von Subbandsignalen oder, in einem extremen Fall ein Block von Spektralkoeffizienten, wenn die Audiofilterbank 125 eine Transformation durchführt, die NSpektralkoeffizienten aus N Zeitbereichs-Abtastwerten erzeugt.

Der BCC-Syntheseblock 122 umfasst ferner eine Verzögerungsstufe 126, eine Pegelmodifikationsstufe 127, eine Korrelationsverarbeitungsstufe 128 und eine Stufe IFB 129, die eine inverse Filterbank darstellt. Am Ausgang der Stufe 129 kann das rekonstruierte Multikanalaudiosignal mit beispielsweise fünf Kanälen im Falle eines 5-Kanal-Surround-Systems an einem Satz von Lautsprechern 124 ausgegeben werden, wie es in Fig. 6 dargestellt ist.

In Fig. 7 ist ferner dargestellt, dass das Eingangssignal s(n) in den Frequenzbereich oder Filterbankbereich mittels des Elements 125 umgesetzt wird. Das Signal, das durch das Element 125 ausgegeben wird, wird so vervielfacht, dass mehrere Versionen desselben Signals erhalten werden, wie es durch den Knoten 130 angedeutet ist. Die Anzahl der Versionen des Ursprungssignals ist gleich der Anzahl von Ausgangskanälen in dem Ausgangssignal, das zu rekonstruieren ist. Wenn jede Version des Ursprungssignals am Knoten 130 einer bestimmten Verzögerung d₁, d₂, ..... dᵢ, d_{N} unterzogen wird, ergibt sich die Situation am Ausgang der Blöcke 126, die die Versionen desselben Signals jedoch mit unterschiedlichen Verzögerungen umfasst. Die Verzögerungsparameter werden durch den Seiteninformationsverarbeitungsblock 123 in Fig. 6 berechnet und aus den Zwischenkanal-Zeitdifferenzen abgeleitet, wie sie durch den BCC-Analyseblock 116 bestimmt worden sind.

Das gleiche gilt für die Multiplikationsparameter a₁, a₂ .... aᵢ, aN, die ebenfalls durch den Seiteninformationsverarbeitungsblock 123 basierend auf den Zwischenkanal-Pegeldifferenzen berechnet werden, die durch den BCC-Analyseblock 116 ermittelt werden.

Die ICC-Parameter werden durch den BCC-Analyseblock 116 berechnet um zum Steuern der Funktionalität des Blocks 128 verwendet, so dass bestimmte Korrelationswerte zwischen den verzögerten und pegelmanipulierten Signalen am Ausgang des Blocks 128 erhalten werden. Es sei darauf hingewiesen, dass die Reihenfolge der Stufen 126, 127, 128 anders sein kann, als sie in Fig. 7 dargestellt ist.

Es sei ferner darauf hingewiesen, dass in einer blockweisen Verarbeitung des Audiosignals die BCC-Analyse ebenfalls blockweise durchgeführt wird. Ferner wird die BCC-Analyse auch frequenzweise, also frequenzselektiv durchgeführt. Dies bedeutet, dass es für jedes spektrale Band einen ICLD= Parameter, einen ICTD-Parameter und einen ICC-Parameter gibt. Die ICTD-Parameter für wenigstens einen Kanal über alle Bänder stellen somit den ICTD-Parametersatz dar. Dasselbe gilt für den ICLD-Parametersatz, der sämtliche ICLDParameter für alle Frequenzbänder zur Rekonstruktion wenigstens eines Ausgangskanals darstellt. Dasselbe gilt wiederum für den ICC-Parametersatz, der wieder mehrere einzelne ICC-Parameter für verschiedene Bänder zur Rekonstruktion wenigstens eines Ausgangskanals auf der Basis des Eingangskanals bzw. Summen-Kanals umfasst.

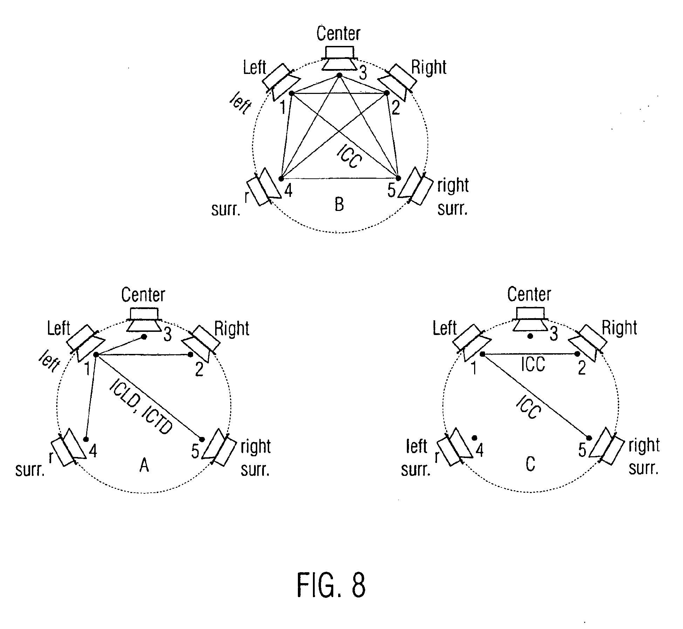

Nachfolgend wird auf Fig. 8 Bezug genommen, die eine Situation zeigt, aus der die Bestimmung von BCC-Parametern ersichtlich ist. Normalerweise können die ICLD-, ICTD- und ICC-Parameter zwischen Kanalpaaren definiert werden. Typischweise wird jedoch eine Bestimmung der ICLD- und der ICTD-Parameter zwischen einem Referenzkanal und jedem anderen Eingangskanal durchgeführt, so dass es für jeden der Eingangskanäle einen eigenen Parametersatz gibt. Dies ist auch in Fig. 8B dargestellt.

Die ICC-Parameter können dagegen unterschiedlich definiert werden. Allgemein kann man ICC-Parameter im Encodierer zwischen allen möglichen Kanalpaaren erzeugen, wie es auch in Fig. 8B schematisch dargestellt ist. In diesem Fall würde ein Decodierer eine ICC-Synthese dahingehend durchführen, dass etwa dasselbe Ergebnis erhalten wird, wie es im ursprünglichen Signal zwischen allen möglichen Kanalpaaren vorgelegen hat. Es wurde jedoch vorgeschlagen, nur ICC-Parameter zwischen den zwei stärksten Kanälen zu jedem Zeitpunkt, also für jeden zeitlichen Frame zu berechnen. Dieses Schema ist in Fig. 8C dargestellt, wo ein Beispiel gezeigt ist, bei dem zu einem Zeitpunkt ein ICC-Parameter zwischen den Kanälen 1 und 2 berechnet und übertragen wird, und bei dem zu einem anderen Zeitpunkt ein ICC-Parameter zwischen den Kanälen 1 und 5 berechnet wird. Der Decodierer synthetisiert dann die Zwischenkanal-Korrelation zwischen den beiden stärksten Kanälen in dem Decodierer und führt weitere typischerweise heuristische Regeln zum Synthetisieren der Zwischenkanal-Kohärenz für die restlichen Kanalpaare aus.

Bezugnehmend auf die Berechnung beispielsweise der Multiplikationsparameter a₁, ..... aN basierend auf den übertragenen ICLD-Parametern wird auf das zitierte AES-Convention-Paper 5574 Bezug genommen. Die ICLD-Parameter stellen eine Energieverteilung in einem ursprünglichen Multikanalsignal dar. Ohne Verlust der Allgemeinheit ist in Fig. 8A gezeigt, dass es vier ICLD-Parameter gibt, die die Energiedifferenz zwischen allen anderen Kanälen und dem vorderen linken Kanal darstellen. In den Seiteninformationenverarbeitungsblock 123 werden die Multiplikationsparameter a₁, ..... aN aus den ICLD-Parametern so abgeleitet, dass die gesamte Energie aller rekonstruierten Ausgangskanäle dieselbe Energie ist, wie sie für das übertragene Summensignal vorliegt, oder wenigstens proportional zu dieser Energie ist. Eine Art und Weise, um diese Parameter zu bestimmen, liegt in einem zweistufigen Prozess, bei dem in einer ersten Stufe der Multiplikationsfaktor für den linken vorderen Kanal auf 1 gesetzt wird, während Multiplikationsfaktoren für die anderen Kanäle in Fig. 8C auf die übertragenen ICLD-Werte gesetzt werden. Dann wird in einer zweiten Stufe die Energie aller fünf Kanäle berechnet und mit der Energie des übertragenen Summensignals verglichen. Dann werden alle Kanäle herunterskaliert, und zwar unter Verwendung eines Skalierungsfaktors, der für alle Kanäle gleich ist, wobei der Skalierungsfaktor so gewählt ist, dass die gesamte Energie aller rekonstruierten Ausgangskanäle nach der Skalierung gleich der Gesamtenergie des übertragenen Summensignals bzw. der übertragenen Summensignale ist.

Bezüglich des Zwischenkanal-Kohärenzmaßes ICC, das von dem BCC-Codierer zu dem BCC-Decodierer als weiterer Parametersatz übertragen wird, sei darauf hingewiesen, dass eine Kohärenzmanipulation durch Modifikation der Multiplikationsfaktoren, wie beispielsweise durch Multiplizieren der Gewichtungsfaktoren aller Subbänder mit Zufallszahlen mit Werten zwischen 20 log10⁻⁶ und 20log10⁶, durchgeführt werden könnte. Die Pseudozufallssequenz wird hierbei typischerweise so ausgewählt, dass die Varianz für alle kritischen Bänder etwa gleich ist und dass der Mittelwert innerhalb jeden kritischen Bandes Null ist. Dieselbe Sequenz wird für die Spektralkoeffizienten jedes unterschiedlichen Frames oder Blocks verwendet. Somit wird die Breite der Audioszene durch Modifikationen der Varianzen der Pseudozufallssequenz gesteuert. Eine größere Varianz erzeugt eine größere Hörbreite. Die Varianzmodifikation kann in individuellen Bändern durchgeführt werden, die eine Breite eines kritischen Bandes haben. Dies ermöglicht die gleichzeitige Existenz mehrerer Objekte in einer Hörszene, wobei jedes Objekt eine unterschiedliche Hörbreite hat. Eine geeignete Amplitudenverteilung für die Pseudozufallssequenz ist eine gleichmäßige Verteilung auf einer logarithmischen Skala, wie es beispielsweise in der US-Patentveröffentlichung 2002/0219130 A1 dargestellt ist.

Um die fünf Kanäle auf kompatible Art und Weise zu übertragen, beispielsweise in einem Bitstromformat, das ebenfalls für einen normalen Stereodecodierer geeignet ist, kann die so genannte Matrizierungstechnik verwendet werden, die in "MUSICAM Surround: A universal multi-channel coding system compatible with ISO/IEC 11172-3", G. Theile und G. Stoll, AES Preprint, Oktober 1992, San Francisco, beschrieben ist.

Ferner wird auf weitere Multikanal-Codiertechniken verwiesen, die in der Publikation "Improved MPEG 2 Audio multi-channel encoding", B. Grill, J. Herre, K. H. Brandenburg, I. Eberlein, J. Koller, J. Miller, AES-Preprint 3865, Februar 1994, Amsterdam, beschrieben ist, wobei eine Kompatibilitätsmatrix verwendet wird, um die Downmix-Kanäle aus den ursprünglichen Eingangskanälen zu erhalten.

Zusammenfassend kann daher gesagt werden, dass die BCC-Technik eine effiziente und auch rückwärtskompatible Codierung von Multikanal-Audiomaterial ermöglicht, wie es auch z. B. in der Fachveröffentlichung von E. Schuijer, J. Breebaart, H. Purnhagen, J. Engdegärd mit dem Titel "Low-Complexity Parametric Stereo Coding", 119. AES Convention, Berlin, 2004, Preprint 6073, beschrieben ist. In diesem Zusammenhang sind auch der MPEG-4-Standard und insbesondere die Erweiterung auf parametrische Audiotechniken zu nennen, wobei dieser Standardteil auch unter der Kennung ISO/IEC 14496-3: 2001/FDAM 2 (Parametric Audio) bekannt ist. Hierbei ist insbesondere die Syntax in Tabelle 8.9 des MPEG-4-Standards mit dem Titel "Syntax der ps-data()" zu nennen. In diesem Beispiel ist das Syntax-Element "enable-icc" und "enable_ipdopd" zu nennen, wobei diese Syntaxelemente dazu verwendet werden, um eine Übertragung eines ICC-Parameters und einer Phase, die Zwischenkanal-Zeitdifferenzen entspricht, ein- und auszuschalten. Ferner wird auf die Syntaxelemente "icc_data()" "ipd_data()" und "opd_data()" verwiesen.

Zusammenfassend sei darauf hingewiesen, dass allgemein gesagt solche parametrischen Multikanaltechniken unter Verwendung von einem oder auch mehreren übertragenen Trägerkanälen eingesetzt werden, wobei also aus N Ursprungskanälen M übertragene Kanäle gebildet werden, um wieder die N Ausgangskanäle oder auch eine Anzahl K von Ausgangskanälen zu rekonstruieren, wobei K kleiner oder gleich der Anzahl der Ursprungskanäle N ist.

Problematisch an allen bisher beschriebenen Techniken ist die Frage, wie eine Formatkompatibilität zwischen unterschiedlichen Typen von Decodierern für die Multikanaldecodierung, beispielsweise für BCC-Decodierer sowie für unterschiedliche Versionen von parametrischen Seiteninformationen geschaffen werden kann. Insbesondere treten zwei Probleme auf, wenn unterschiedliche Multikanaldecodierer auf dem Markt sind, während gleichzeitig Seiteninformationen mit unterschiedlichen Parametersätzen, die von unterschiedlichen Multikanaldecodierern erzeugt worden sind, gleichzeitig auf dem Markt sind und somit für den Benutzer, der nur einen einzigen Decodierer hat, verfügbar sind.

Zunächst ist es wünschenswert, Decodierer mit hoher Rechenkapazität zu haben, die die bestmögliche Multikanal-Tonqualität bei der Decodierung liefert. Gleichzeitig werden jedoch auch Decodierer existieren, die unter Ressourcen-begrenzten Bedingungen betrieben werden, wie beispielsweise Decodierer in mobilen Geräten, wie Mobiltelefonen. Solche Decodierer sollten natürlich eine Multikanalausgabe mit noch möglichst guter Qualität liefern, aber gleichzeitig nur einen begrenzten Rechenaufwand haben. Dies führt zur Frage, ob es Bitstromformate mit Parametersätzen zur räumlichen Rekonstruktion geben kann, die diese Art der Skalierbarkeit unterstützen, die also sowohl eine Decodierung mit hoher Komplexität und damit optimaler Qualität als auch eine Dekodierung mit reduzierter Komplexität, jedoch auch entsprechend reduzierter Qualität ermöglichen.

Ein weiterer Aspekt, der berücksichtigt werden muss, wenn neue Generationen/Versionen von BCC-Codierern und somit von BCC-Bitströmen eingeführt werden, liegt in der Frage, wie eine Kompatibilität zwischen unterschiedlichen Versionen von BCC-Bitströmen und BCC-Decodierern beibehalten werden kann. Mit anderen Worten ausgedrückt ist es sehr wünschenswert, dass neue BCC-Parametersätze und auch aktualisierte alte Parametersätze rückwärtskompatibel sind. So ist es natürlich wünschenswert einen Upgrade-Pfad für BCC-Benutzer zu liefern, der es ermöglicht, neue verbesserte Multikanal-Schemen einzuführen, wenn solche aufgrund des technischen Fortschritts verfügbar sind. Andererseits führen neue BCC-Bitstrom-Formate üblicherweise zu Inkompatibilitäten zwischen diesen Bitströmen und verschiedenen (älteren) BCC-Decodiererversionen.

Insbesondere sei darauf hingewiesen, dass Multikanalcodierer/Decodierer in immer mehr Anwendungsfeldern eingesetzt werden sollen, die nicht unbedingt die maximale Rechenkapazitäten verfügbar haben, die jedoch auch nicht immer unbedingt die volle Tonqualität erfordern.

Die Fachveröffentlichung "MP3 Surround: Efficient and Compatible Coding of Multi-Channel Audio", Jürgen Herre, u.a. AES Convention Paper, 116te AES Convention, 8. bis 11. Mai 2004, Berlin, Deutschland, offenbart eine allgemeine Struktur eines MP3-Surround-Kodierers mit einem Down-Mixer, einem BCC-Kodierer und einem Standard-MP3-Kodierer, der ein Stereo-Down-Mix-Signal kodiert und Surround-Enhancement-Daten als "Ancillary Data" in den MP3-Surround-Bitstrom schreibt. Die Surround-Enhancement-Daten umfassen einen Satz von räumlichen Parametern (ICLD, ICTD, ICC). Auf Dekodierer-Seite werden die Surround-Enhancement-Daten aus dem Ancillary-Data-Field ausgelesen und einem dem Standard-MP3-Dekodierer nachgeschalteten BCC-Kodierer übermittelt.

Die Fachveröffentlichung "Advances in Parametric Coding for High-Quality Audio", E. Schuijers et al., IEEE Benelux Workshop on Model based Processing and Coding of Audio (MPCA-2002), 15. November 2002, Seiten 73-79 offenbart ein Konzept, das im Gegensatz zu traditionellen Wellenform-Codierstandards, die eine Subband-Codierung oder eine Transformations-Kodierung einsetzen, mit einer parametrischen Codierung eine weitere Reduktion der Bitraten erlaubt. In einer skalierbaren Bitstromsyntax sind die Stereo-Parameter über eine Stereo-Basisschicht und eine Stereo-Erweiterungsschicht in skalierbarer Art und Weise verteilt. Die Stereo-Basisschicht enthält Werte, die den gesamten Frequenzbereich betreffen, also einen einzigen IID-Parameter, einen einzigen ITD-Parameter und einen einzigen ICC-Parameter, wobei jeder Parameter den gesamten Frequenzbereich abdeckt. Die Stereo-Erweiterungsschicht enthält Parameterwerte für Bänder des kompletten Frequenzbereichs, also einen Satz von IID-Parametern, einen Satz von ITD-Parametern und einen Satz von ICC-Parametern, die zusammen jeweils den gesamten Frequenzbereich abdecken.

Die Aufgabe der vorliegenden Erfindung besteht darin, ein Konzept zu schaffen, das effizient und flexibel ist, das also z. B. die Integration neuer Parametersätze oder die Aktualisierung alter Parametersätze erlaubt und zugleich flexibel in einer Vielzahl von unterschiedlichen Anwendungen eingesetzt werden können.

Diese Aufgabe wird durch eine Vorrichtung zum Erzeugen eines codierten Multikanalsignals gemäß Patentanspruch 1, eine Vorrichtung zum Decodieren eines codierten Multikanalsignals gemäß Patentanspruch 2, ein Verfahren zum Erzeugen eines codierten Multikanalsignals gemäß Patentanspruch 15, ein Verfahren zum Decodieren eines Multikanalsignals gemäß Patentanspruch 16 oder ein Computer-Programm gemäß Patentanspruch 17 gelöst.

Der vorliegenden Erfindung liegt die Erkenntnis zugrunde, dass eine effiziente und rückwärtskompatible Decodierung von codierten Multikanalsignalen dann erreicht wird, wenn das codierte Multikanalsignal als Datenstrom geschrieben wird, der neben dem wenigstens einen Obertragungskanal bzw. Trägerkanal wenigstens zwei unterschiedliche Parametersätze umfasst, wobei die beiden Parametersätze so in den Datenstrom geschrieben sind, dass eine Rekonstruktion der Ausgangskanäle mit weniger als den wenigstens zwei Parametersätzen erfolgen kann. Der Datenstrom wird erfindungsgemäß so geschrieben, dass ein Decodierer erkennen kann, welcher der Parametersätze zur Rekonstruktion benötigt wird, und welcher Parametersatz optional zur Rekonstruktion nötig ist. Ein Decodierer kann dann in diesem Fall lediglich den Parametersatz, der zur Rekonstruktion unverzichtbar (d.h. obligatorisch) ist, verwenden, und, sofern es äußere Umstände vorgeben, die optionalen Parametersätze einfach ignorieren. Dies führt dazu, dass der Decodierer dann, wenn er nur den unbedingt erforderlichen Parametersatz zur Rekonstruktion verwendet, schnell ist und mit begrenzter Rechenkapazität auskommt, während gleichzeitig, aufgrund desselben Datenstroms, der das codierte Multikanalsignal darstellt, ein anderer Decodierer eine hoch-qualitative Multikanal-Rekonstruktion durchführen kann, die jedoch auch mehr Zeit bzw. mehr Rechenkapazität bzw. allgemeiner gesagt mehr Decodiererressourcen benötigt.

Bei einem bevorzugten Ausführungsbeispiel der vorliegenden Erfindung ist der unbedingt nötige Parametersatz der, der die Zwischenkanal-Pegeldifferenzen umfasst. Diese Zwischenkanal-Pegeldifferenzen sind, wie erfindungsgemäß herausgefunden worden ist, außerordentlich wichtig, um die grundsätzliche Multikanal-Tonverteilung zwischen den Ausgangskanälen für alle Typen von Wiedergabesituationen zu definieren. Die Zwischenkanal-Zeitdifferenzen können als optionale Parametersätze klassifiziert werden, da sie hauptsächlich relevant sind, wenn eine Präsentation über entweder Kopfhörer, also zwei Ausgangskanäle aus einem übertragenen Kanal, zu erfolgen hat, oder wenn eine Multikanal-Audiodarstellung in einer sogenannten relativ "trockenen" akustischen Situation erfolgt, also einer akustischen Situation, die wenig Echos umfasst. Die Zwischenkanal-Zeitdifferenzen können daher bereits als optionaler Parametersatz klassifiziert werden.

Die Zwischenkanal-Korrelationswerte sind wichtig, um die Breite von Schallquellen zu liefern, und um ferner für einen Zuhörer den Eindruck zu erzeugen, dass er sich in einem Szenario mit komplexen Schallquellen, beispielsweise einem klassischen Orchester, befindet, das viele unkorrelierte Schallkomponenten umfasst. Auch der ICC-Parametersatz kann somit als optionaler Parametersatz klassifiziert werden, da er selbstverständlich einen wesentlichen Einfluss auf die Qualität hat, jedoch in der Rekonstruktion vielfach zu einem relativ großen Rechenaufwand führt, welcher z. B. bei dem unbedingt erforderlichen Parametersatz der Zwischenkanal-Pegeldifferenzen nicht so erheblich ist, da hier im Wesentlichen nur eine Gewichtungsoperation, also eine rechenmäßig effizient ausführbare Multiplikation erforderlich ist.

Im Hinblick auf das Problem der Rückwärtskompatibilität von codierten Multikanalsignalen mit Parametersätzen in den Datenströmen wird der Parametersatz, der z. B. eine höhere Versionsnummer hat, derart in den Datenstrom geschrieben, dass eine Rekonstruktion durch einen Decodierer ohne diesen Parametersatz erfolgen kann, was dazu führt, dass ein Decodierer dann, wenn er feststellt, dass er diesen zweiten Parametersatz nicht verarbeiten kann, zur Rekonstruktion lediglich den ersten Parametersatz verwendet und den zweiten Parametersatz einfach übergeht.

Auf Decodiererseite bedeutet dies, dass der Decodierer dann, wenn er einen Parametersatz als unbedingt erforderlichen Parametersatz identifiziert hat, diesen Parametersatz komplett einlesen und verarbeiten muss, dass der Decodierer jedoch dann, wenn er auf einen Parametersatz stößt, der zur Rekonstruktion nicht unbedingt erforderlich ist, der also als optional markiert ist, die Bits im Bitstrom, die zu diesem Parametersatz gehören, einfach übergeht. Der Decodierer muss daher, um mit dem codierten Multikanalsignal etwas anfangen zu können, keine Kenntnis über die Syntax des zweiten Parametersatzes haben, sondern kann diesen einfach übergehen und mit den anschließenden Bereichen des codierten Multikanalsignals, die er unter Umständen noch zur Rekonstruktion benötigt, einfach fortfahren.

Vorzugsweise wird daher für als optional markierte Parametersätze eine Längeninformation in den Datenstrom eingetragen, die dem Decodierer schnell und effizient erlauben, die zu diesem Parametersatz zugehörigen Bits einfach zu übergehen, und lediglich zur Decodierung die als obligatorisch markierten Parametersätze zu nehmen. Im Hinblick auf die Rückwärtskompatibilität wird es ferner bevorzugt, dass wenigstens jedem optionalen Parametersatz eine Versionsnummer zugeordnet wird, die angibt, von welcher Codiererversion dieser Parametersatz erzeugt worden ist. In einem Datenstrom würde daher z. B. der Parametersatz für die Zwischenkanal-Pegeldifferenzen der niedrigsten Version als unbedingt erforderlich markiert sein, während ein Parametersatz für Zwischenkanal-Pegeldifferenzen einer späteren Codiererversion eine andere Versionsnummer erhält, so dass ein Decodierer dann, wenn er feststellt, das er den Parametersatz mit höherer Versionsnummer nicht verarbeiten kann, einfach zur Rekonstruktion den entsprechenden Parametersatz mit niedrigerer Versionsnummer verwendet.

Schließlich sei darauf hingewiesen, dass der Datenstrom, der das Multikanalsignal darstellt, nicht unbedingt auch die Übertragungskanäle enthalten muss. Vielmehr können diese separat erzeugt und übertragen worden sein, wie beispielsweise in einem Fall, in dem nachträglich die BCC-Parameter auf eine CD in einen entsprechenden Kanal geschrieben werden, wobei die CD bereits die M (= größer oder gleich 1) Übertragungskanäle enthält.

Bevorzugte Ausführungsbeispiele der vorliegenden Erfindung werden nachfolgend bezugnehmend auf die beiliegenden Zeichnungen detailliert erläutert. Es zeigen:
- Fig. 1a: eine Übersicht über ein codiertes Multikanalsignal mit einer bestimmten Datenstromsyntax gemäß einem Ausführungsbeispiel der vorliegenden Erfindung;
- Fig. 1b: eine detailliertere Darstellung des ControlBlocks von Fig. 1a gemäß einem Ausführungsbeispiel der vorliegenden Erfindung;
- Fig. 2a: ein Blockschaltbild eines Codierers gemäß einem Ausführungsbeispiel der vorliegenden Erfindung;
- Fig. 2b: ein Blockschaltbild eines Decodierers gemäß einem Ausführungsbeispiel der vorliegenden Erfindung;
- Fig. 3a: bis 3d eine bevorzugte Ausführungsform für die Parametersatz-Konfiguration gemäß der vorliegenden Erfindung;
- Fig. 4a: bis 4c eine bevorzugte Ausführungsform der Parametersatz-Daten gemäß der vorliegenden Erfindung;
- Fig. 5: eine allgemeine Darstellung eines MultikanalCodierers;
- Fig. 6: ein schematisches Blockdiagramm einer BCC-Codierer/BCC-Decodierer-Strecke;
- Fig. 7: ein Blockschaltbild des BCC-Syntheseblocks von Fig. 6; und
- Fig. 8A: bis 8C eine Darstellung von typischen Szenarien. zur Berechnung der Parametersätze ICLD, ICTD und ICC.

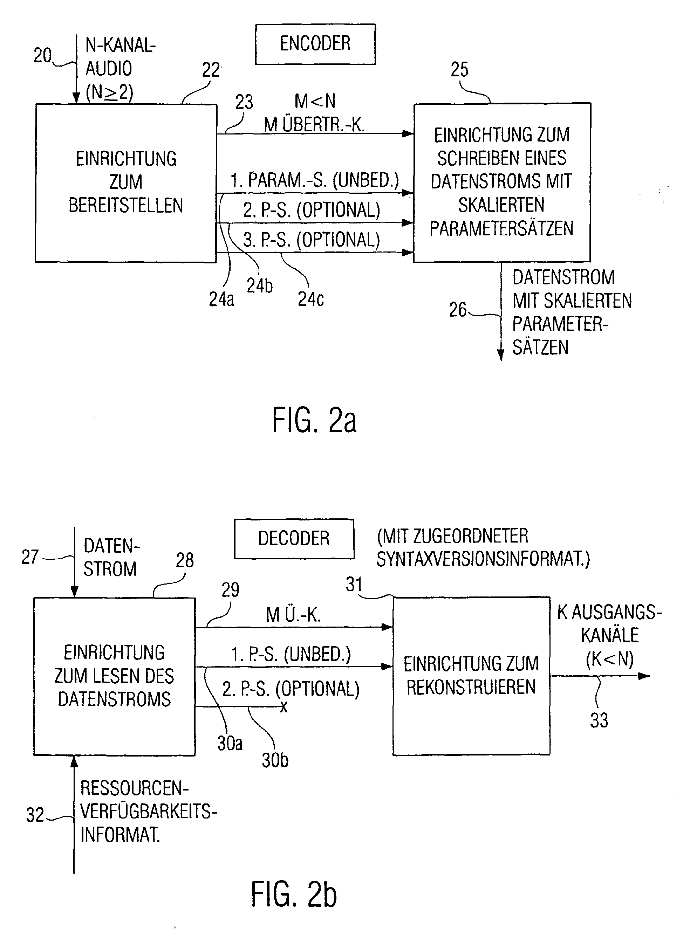

Fig. 2a zeigt eine bevorzugte Ausführungsform einer Vorrichtung zum Erzeugen eines codierten Multikanalsignals, das ein uncodiertes Multikanalsignal darstellt, das N Ursprungskanäle aufweist, welche in einen Eingang 20 einer Einrichtung 22 zum Bereitstellen sowohl von M Übertragungskanälen als auch von Parameterinformationen mit wenigstens zwei Parametersätzen eingespeist werden. Insbesondere ist die Anzahl M von Übertragungskanälen, die an einem Ausgang 23 der Einrichtung 22 ausgegeben werden, kleiner als die Anzahl N von ursprünglichen Audiokanälen. An Ausgängen 24a, 24b, 24c der Einrichtung 22 zum Bereitstellen liegen die einzelnen Parametersätze an, die zusammen die Parameterinformationen zum Rekonstruieren von K Ausgangskanälen darstellen. Die M Übertragungskanäle, wobei M größer oder gleich 1 und kleiner als N ist, werden ebenso wie die Parametersätze an den Ausgängen 24a, 24b, 24c einer Einrichtung 25 zum Schreiben eines ausgangsseitigen Datenstroms, der an einem Ausgang 26 anliegt, zugeführt.

Wie es ausgeführt worden ist, können die Downmix-Informationen (M Übertragungskanäle) auch von den Parameterinformationen separat übertragen/gespeichert werden.

Die Einrichtung 25 zum Schreiben des Datenstroms, der das codierte Multikanalsignal darstellt, ist ausgebildet, um die M Übertragungskanäle in den Datenstrom zu schreiben und ferner den ersten, den zweiten und den dritten Parametersatz so in den Datenstrom zu schreiben, dass eine Rekonstruktion der K-Ausgangskanäle ohne Verwendung eines der drei Parametersätze und vorzugsweise sogar ohne Verwendung von wenigstens zwei der drei Parametersätze erfolgen kann. Insofern sind die Parametersätze an den Ausgängen 24a bis 24c der Einrichtung 22 zum Bereitstellen so markiert, dass ein Parametersatz, wie beispielsweise der erste Parametersatz unbedingt zur Rekonstruktion benötigt wird, während die beiden weiteren Parametersätze, nämlich der zweite Parametersatz und der dritte Parametersatz so definiert sind, dass sie nur optional zur Rekonstruktion benötigt werden.

Die Einrichtung 25 zum Schreiben wird dann den ersten Parametersatz als unbedingt erforderlichen Parametersatz in den Datenstrom schreiben und den zweiten Parametersatz und den dritten Parametersatz lediglich als optionale Parametersätze in den Datenstrom schreiben, wie es nachfolgend noch dargelegt wird.

Der Datenstrom am Ausgang 26 von Fig. 2a wird in einen Datenstromeingang 27 eines Multikanal-Decodierers eingespeist, der in Fig. 2b dargestellt ist. Die Daten des Datenstroms werden einer Einrichtung 28 zum Lesen des Datenstroms zugeführt, wobei die Einrichtung 28 zum Lesen des Datenstroms ebenso wie der in Fig. 2a gezeigte Encodierer wiederum einen logischen Ausgang 29 für die aus dem Datenstrom extrahierten M Übertragungskanäle sowie weitere logische Ausgänge 30a, 30b für die Parametersätze aufweist, die in dem Datenstrom enthalten sind. In einem bevorzugten Ausführungsbeispiel der vorliegenden Erfindung, bei dem der erste Parametersatz als unbedingt zur Rekonstruktion erforderlich markiert ist, wird die Einrichtung 28 zum Lesen diesen ersten Parametersatz über den logischen Ausgang 30a einer Einrichtung 31 zum Rekonstruieren bereitstellen. Wenn die Einrichtung 28 zum Lesen beispielsweise fest eingestellt ist, um nur die unbedingt erforderlichen Parametersätze zu lesen und der Einrichtung 31 zum Rekonstruieren zuzuführen, so wird die Einrichtung 28 den zweiten Parametersatz im Datenstrom am Eingang 27 einfach übergehen, was durch den unterbrochenen logischen Ausgang 30b in Fig. 2b symbolisch dargestellt ist.

Die Steuerung, ob lediglich unbedingt erforderliche Parametersätze oder zusätzlich auch optionale Parametersätze aus dem Datenstrom extrahiert und einer Einrichtung 31 zugeführt werden, kann auch über einen Steuereingang 32 der Einrichtung 28 zugeführt werden, wobei über den Steuereingang 32 Ressourcenverfügbarkeitsinformationen bzw. davon abgeleitete Steuerinformationen eintreffen.

Eine Ressourcenverfügbarkeitsinformation kann beispielsweise darin bestehen, dass ein batteriebetriebener Decodierer feststellt, dass er noch ausreichend Batterieleistung zur Verfügung hat, so dass die Einrichtung 28 zum Lesen des Datenstroms angewiesen wird, um nicht nur die unbedingt erforderlichen Parametersätze, sondern auch die optionalen Parametersätze zu extrahieren und über entsprechende logische Ausgänge der Einrichtung 31 zum Rekonstruieren zuzuführen, damit diese wiederum K Ausgangskanäle an einem Ausgang 33 bereitstellt, wobei K kleiner oder gleich der ursprünglichen Anzahl N von ursprünglichen Eingangskanälen am Eingang 20 von Fig. 2a ist. Es sei darauf hingewiesen, dass vorzugsweise die Anzahl K gleich der Anzahl N ist, da ein Decodierer möglicherweise den Wunsch haben wird, sämtliche im Datenstrom codierten Ausgangskanäle zu erzeugen.

Die Datenstrom-Leseeinrichtung 28 zum Lesen des Datenstroms ist also wirksam, um dann, wenn die Skalierbarkeit im Datenstrom ausgenützt wird, wenn also ein Parametersatz im Datenstrom nicht zur Rekonstruktion verwendet wird, wenigstens den ersten Parametersatz einzulesen und wenigstens einen Parametersatz, wie beispielsweise den zweiten Parametersatz übergehen zu können. Die Rekonstruktionseinrichtung 31 dann wirksam ist, um die K Ausgangskanäle unter Verwendung der M Übertragungskanäle und des ersten Parametersatzes, nicht aber unter Verwendung des zweiten Parametersatzes zu rekonstruieren.

Bei einem Ausführungsbeispiel der vorliegenden Erfindung ist die Einrichtung 22 zum Bereitstellen ein BCC-Codierer, der die N Ursprungskanäle erhält und ausgangsseitig die M Übertragungskanäle sowie die einzelnen Parametersätze liefert. Alternativ kann die Einrichtung 22 zum Bereitstellen auch ein sog. Bitstrom-Transcodierer sein, der eingangsseitig bereits in einem nicht-skalierbaren Format geschriebene Informationen (nur Parametersätze oder Parametersätze samt Übertragungskanäle) erhält, wie sie z. B. durch die Elemente 114 und 116 von Fig. 7 erzeugt werden, und der die Einrichtung 25 zum Schreiben entsprechend anweist, um den Bitstrom umzuschreiben, um also die Parametersätze in den Datenstrom in skalierbarer Form zu schreiben. Dies bedeutet, dass ein Decodierer, um den Datenstrom verstehen zu können, nicht sämtliche Daten des Datenstroms einlesen und parsen muss, sondern dann, wenn er einen optionalen Parametersatz erkennt, die Daten, die zu diesem optionalen Parametersatz gehören, übergehen kann.

So existieren zum tatsächlichen Schreiben des Datenstroms mit den skalierten Parametersätzen verschiedene Möglichkeiten. Bei einem Ausführungsbeispiel kann der Beginn der Daten für einen Parametersatz gemäß einem festen Datenstromraster festgelegt sein. In einem solchen Fall ist die Übertragung von einer Längeninformation, die einem optionalen Parametersatz zugeordnet ist, nicht unbedingt erforderlich. Dieses feste Raster kann jedoch dazu führen, dass die Datenmenge des Datenstroms künstlich durch Auffüllbits aufgebläht wird. Es wird daher bevorzugt, jedem optionalen Parametersatz eine Längeninformation zuzuordnen, damit ein Decodierer dann, wenn er die Information hat, einen optionalen Parametersatz übergeht, also einfach aufgrund der Längeninformation eine bestimmte Anzahl von Bits in dem vorzugsweise seriell vorliegenden Datenstrom überspringt, um dann an der richtigen Stelle des Datenstroms, also dann, wenn Daten für einen neuen Parametersatz bzw. für neue Informationen starten, wieder mit dem Einlesen und Analysieren einzusetzen.

Eine alternative Möglichkeit der Signalisierung des Beginns eines neuen Parametersatzes besteht beispielsweise darin, den eigentlichen Daten ein Synchronisationsmuster voranzustellen, das ein bestimmtes Bitmuster hat, das also ohne tatsächliche Analyse der Daten allein aufgrund einer Bitmustersuche erkannt werden kann, um einem Decodierer zu signalisieren, dass hier die Daten für einen Parametersatz beginnen und beim darauf folgenden Synchronisationsmuster enden. In einem solchen Fall würde ein Decodierer dann, wenn ein Parametersatz als optionaler Parametersatz identifiziert worden ist, ein Synchronisationsmuster suchen, das dem Beginn des optionalen Parametersatzes zugeordnet ist, um dann ohne syntaktische Analyse mit den auf das Synchronisationsmuster folgenden Bits eine Mustersuche durchzuführen, bis er auf das nächste Synchronisationsmuster stößt. Die zwischen den beiden Synchronisationsmustern liegen Bits würden dann für eine Rekonstruktion nicht verwendet werden, sondern einfach ignoriert werden, während die Daten am darauf folgenden Synchronisationsmuster, das das Ende des optionalen Parametersatzes signalisiert, eingesetzt werden können, wie es gemäß der Bitstromsyntax vorgeschrieben ist, sofern diese Daten nicht zu einem weiteren optionalen Parametersatz gehören.

Bei einem bevorzugten Ausführungsbeispiel der vorliegenden Erfindung werden die wenigstens zwei Parametersätze, die zur Rekonstruktion der mehreren Kanäle benötigt werden, hinsichtlich ihrer wahrnehmungsmäßigen Bedeutung klassifiziert. Der für die Wahrnehmung, also für die Qualität des rekonstruierten Multikanalsignals bedeutsamste Parametersatz wird als unbedingt erforderlicher Parametersatz im Datenstrom markiert, während die anderen Parametersätze lediglich als optionale Parametersätze markiert werden. Weitere Abstufungen in unbedingt erforderlich, optional und z. B. nur für eine Studio-Rekonstruktion erforderliche Parametersätze können ebenfalls durchgeführt werden, um z. B. drei Skalierungsstufen anstatt leidlich zwei Skalierungsstufen zu erreichen. Es sei darauf hingewiesen, dass es genügt entweder die obligatorischen oder vorzugsweise die optionalen Parametersätze zu markieren, da sich die Art des jeweils nicht markierten Parametersatzes automatisch aus dem Nicht-Vorhandensein einer Markierung ergibt.

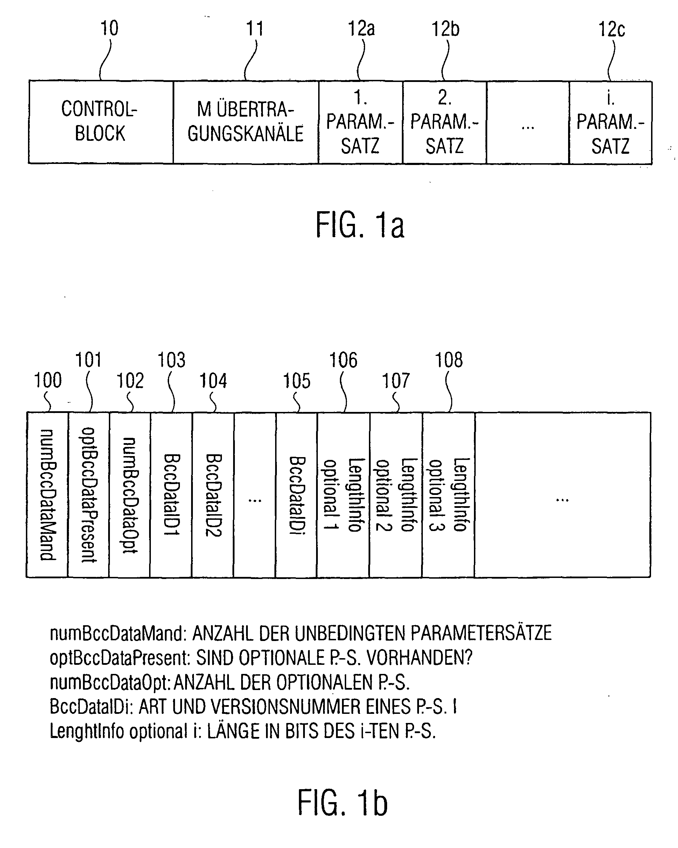

Fig. 1a zeigt eine schematische Darstellung des Datenstroms, der bei dem mit Fig. 1a gezeigten Ausführungsbeispiel zunächst einen Control-Block 10, einen Block, in dem die Daten der M Übertragungskanäle stehen, der mit 11 bezeichnet ist, sowie für jeden Parametersatz einen Block 12a, 12b, ..... 12c umfasst. Bei dem bevorzugten Ausführungsbeispiel der vorliegenden Erfindung umfasst der Control-Block 10 verschiedene einzelne Informationen, wie sie in Fig. 1b schematisch dargestellt sind. So wird in einem Eintrag 100 in dem Control-Block 10 die Anzahl der unbedingt erforderlichen Parametersätze durch ein Feld mit dem Titel "numBccDataMand" signalisiert. Ferner wird in einem Feld 101 signalisiert, ob optionale Parametersätze vorhanden sind. Zu diesem Zweck wird ein mit "OptBccDataPresent" markiertes Feld eingesetzt. In einem weiteren Feld des Control-Blocks 10 wird ferner die Anzahl der optionalen Parametersätze mit der Variable "numBccDataOpt" signalisiert. In weitern Blöcken 103, 104, 105 wird für jeden Parametersatz die Art und/oder die Versionsnummer eines Parametersatzes i signalisiert. Hierzu wird das Feld mit den Namen "BccDataId" eingesetzt. In einer weiteren optional vorhandenen Folge von Feldern 106, 107, 108 wird jedem Parametersatz, der als optional markiert worden ist, der also in der Anzahl der optionalen Parametersätze enthalten ist, eine optionale Längeinformation gegeben, die mit "Lengthinfo" bezeichnet ist. Diese Längeninformationen gibt die Länge in Bits des entsprechenden zugeordneten z. B. i-ten Parametersatzes an. Wie es später noch dargelegt wird, kann "Lengthinfo" auch eine Information über die Anzahl von Bits, die zur Signalisierung der Länge erforderlich sind, oder alternativ auch die eigentliche Längenangabe umfassen.

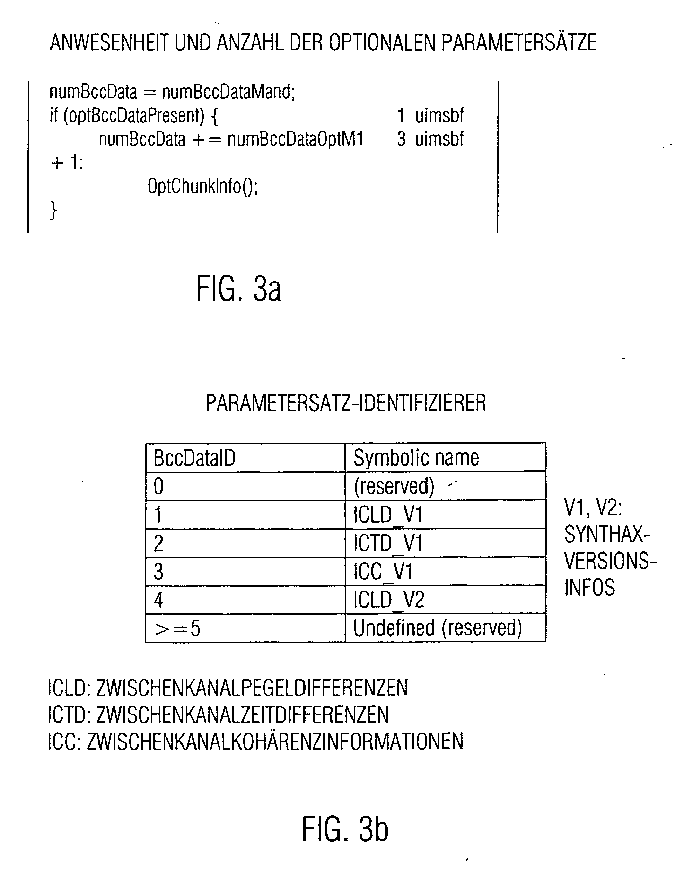

Die Fig. 3a bis 3d zeigen eine bevorzugte Form der Parametersatzkonfiguration. Die Parametersatzkonfiguration kann für jeden Frame erfolgen, kann aber auch z. B. nur einmal für eine Gruppe von Frames erfolgen, wie z. B. am Anfang eines files, das viele Frames enthält. So ist in Fig. 3a eine Definition der Anwesenheit und Anzahl der optionalen Parametersätze im Pseudocode gegeben, wobei "uimsbf" für "unsigned integer most significant bit first", also für eine Ganzzahl steht, die kein Vorzeichen umfasst, und deren höchstwertiges Bit zuerst im Datenstrom steht. So ist zunächst die Variable numBccData, die die Anzahl der BCC-Daten spezifiziert, z. B. im Feld 100 des Control-Blocks 10 dargestellt.

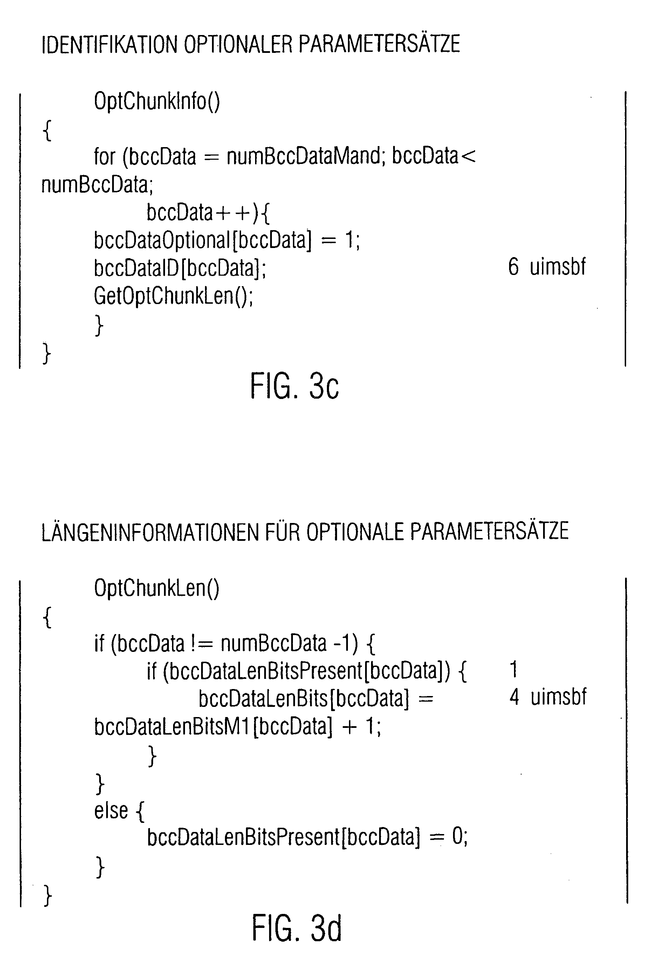

Ferner wird das Feld 101 verwendet, um festzustellen, ob überhaupt optionale Parametersätze vorhanden sind (optBccDataPresent). Hierauf wird die Anzahl (numBccDataOpt) der optionalen Parametersätze eingelesen, um dann, wenn dies geschehen ist, weitere Informationen über die optionalen Parametersätze bzw. sog. "Chunks" zu erhalten (OptChunkInfo). Die Variable numBccDataOptM1 enthält das Suffix "M1", das für "Minus 1" steht. Dies wird durch Addition von "+1" in Fig. 3d wieder ausgeglichen.

Fig. 3b zeigt eine Übersicht über den Wert, den bei einem Ausführungsbeispiel der Parametersatz-Datenidentifizierer in den Feldern 103 bis 105 haben kann. So kann die Variable "BccDataId" zunächst den Name, also die Art des Parameters umfassen, also ICLD, ICTD und ICC, und zugleich eine Versionsnummer V1 bzw. V2 umfassen. So ist in Fig. 3b zu sehen, dass ein Datenstrom tatsächlich gleichzeitig die Zwischenkanal-Pegeldifferenzen einer ersten Version V1 und einer späteren zweiten Version V2 enthalten kann, wobei ein entsprechend geeigneter Decodierer für die erste Version einfach als unbedingt erforderlichen Parametersatz ICLD_V1 einlesen kann und ICLD_V2 ignorieren kann, während ein Decodierer mit höherer Versionsnummer einfach ICLD_V2 einlesen kann, und zwar als unbedingt erforderlichen Parametersatz, um jedoch ICLD_V1 als in diesem Szenario nur optional erforderlichen Parametersatz zu ignorieren. Alternativ kann der Datensatz so geschrieben sind, dass die obligatorischen Datensätze immer nur in einer Version im Datenstrom vorkommen.

Fig. 3c zeigt die Identifikation optionaler Parametersätze. So wird in den Informationen über optionale Parametersätze für jeden Parametersatz der Parametersatzidentifizierer 103 bis 105 von Fig. 1b eingelesen, um Informationen über jeden Parametersatz, der optional ist, zu erhalten. Ferner wird für jeden optionalen Parametersatz die Länge dieses Parametersatzes eingelesen, insofern diese im Bitstrom mit übertragen wurde, wie es durch den Befehl " OptChunkLen()" in Fig. 3c dargestellt ist.

Bezüglich der Ermittlung der Längeninformationen für optionale Parametersätze wird auf Fig. 3d verwiesen, wo dargestellt ist, wie die Länge in Bits für jeden Parametersatz bei einem bevorzugten Ausführungsbeispiel der vorliegenden Erfindung aus den Daten, die jedem optionalen Parametersatz zugeordnet sind, eingelesen wird.

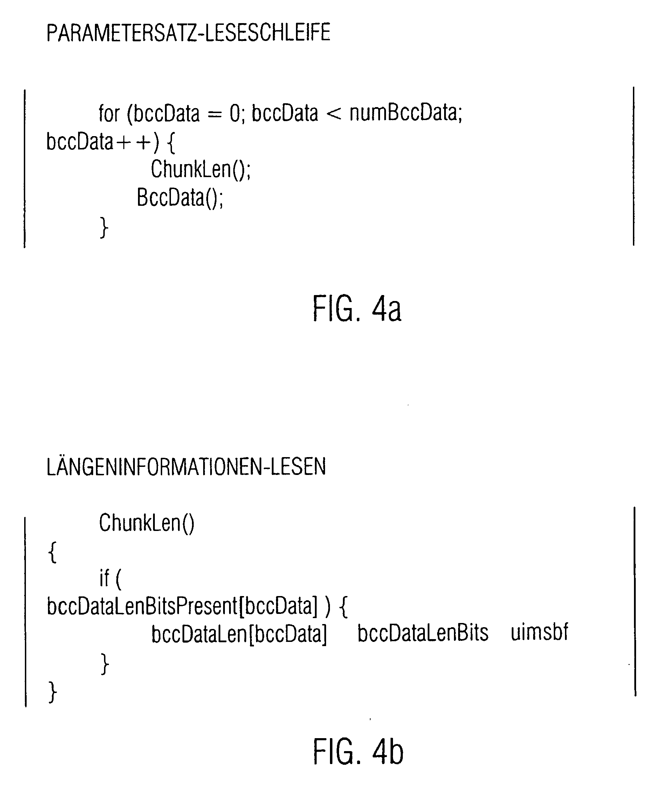

Die von einem Decodierer durchgeführte Parametersatz-Leseschleife ist in Fig. 4a schematisch dargestellt. So werden die tatsächlichen Parametersatzdaten, die in den Blöcken 12a bis 12c von Fig. 1 stehen, mit BccData() eingelesen.

Das Lesen der Längeninformationen ist in Fig. 4b dargestellt. So beschreibt BccDataLenBits die Anzahl der Bits, die zum Signalisieren der tatsächlichen Bitlänge eines Chunks nötig sind. BccDataLen gibt dann tatsächlich die Länge in Bits an, die ein Chunk hat. Dieses zweistufige System ist einerseits flexibel und andererseits datensparend, da es besonders dann effizient ist, wenn die chunks eine stark abweichende Länge in Bits haben, was besonders für Parametersätze sehr unterschiedlicher Art und damit Länge zutrifft. Dies erlaubt zukünftig die Definition weiterer Chunks mit nahezu beliebiger Länge.

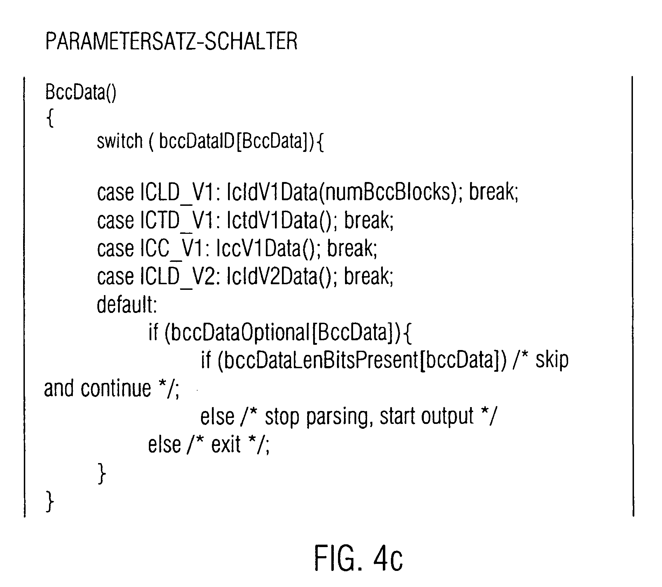

Fig. 4c stellt schließlich den Parametersatz-Schalter dar, wobei hier der Parametersatz-Identifizierer, wie er in Fig. 3b dargestellt worden ist, ausgewertet wird, derart, dass Parametersätze den entsprechenden Rekonstruktionsalgorithmen zugeordnet werden, damit also nicht der Fall eintritt, dass z. B. Zwischenkanal-Pegeldifferenzen für Zwischenkanal-Zeitdifferenzen gehalten werden und umgekehrt.

Aus Fig. 4c ist ferner zu sehen, dass dann, wenn ein Parametersatz als optional erkannt worden ist und eine Decodierung unter Verwendung des optionalen Parametersatzes nicht erwünscht ist, die Anzahl von Bits dieses Parametersatzes übergangen wird ("Skip and Continue"), um dann, wenn alle bereits unbedingt erforderlichen Parametersätze eingelesen worden sind (oder für den Decodierer unbekannte Daten, z. B. Parametersätze, auftreten), ohne Rücksicht auf weitere optionale Parametersätze mit der Ausgabe zu beginnen ("Stop Parsing, Start Output"). Ein solcher Decodierer wird daher dann, wenn er bereits wenigstens einen obligatorischen Chunk eingelesen hat, und er weitere Informationen im Datenstrom nicht parsen kann, mit der Ausgabe beginnen. Der Decodierer wird also nicht durch einen Datenstrominhalt, den er nicht versteht, zum kompletten Fehlerausstieg gebracht. Damit wird ein sehr robuster Decodierer geschaffen.

Nachfolgend wird die Funktionalität der vorliegenden Erfindung anhand bevorzugter Ausführungsbeispiele der vorliegenden Erfindung noch detaillierter dargelegt. So werden Parameterinformationen unterschiedlicher Art, wie beispielsweise ICLDs, ICTDs, ICCs und andere Parametersatzinformationen, in unterschiedlichen und getrennten Datenabschnitten untergebracht, also in verschiedenen Skalierungsschichten. Zu diesem Zweck sei noch einmal auf Fig. 4a bis 4c verwiesen. Die Parametersätze werden in unbedingt erforderliche oder (obligatorische) Parametersätze, wie beispielsweise Zwischenkanal-Pegeldifferenzen-Parametersätze und optionale Parametersätze, wie beispielsweise Zwischenkanal-Zeitdifferenzen-Parametersätze und Zwischenkanal-Korrelationswert-Parametersätze, unterschieden.

Informationen über die Anzahl von unbedingt erforderlichen Parametersätzen (numBccDataMand) und die Anwesenheit (OptBccDataPresent) und die Anzahl von optionalen Parametersätzen (numBccDataOpt) werden bereitgestellt. Üblicherweise hängt die Information über die Anzahl von unbedingt erforderlichen Parametersätzen (numBccDataMand) von der Systemspezifikation ab und muss daher nicht unbedingt explizit übertragen werden, sondern kann zwischen dem Encodierer und dem Decodierer fest vereinbart sein. Dagegen wird es bevorzugt, die Anzahl von optionalen Parametersätzen (numBccDataOpt) explizit zu übertragen. Wenn der Anwesenheitsparameter (OptBccDataPresent) die Anwesenheit von optionalen Parametersätzen anzeigt, wie es in Fig. 3a dargestellt ist, wird eine entsprechende Auswertung der Informationen über die optionalen Parametersätze gestartet.

Ferner wird bei dem bevorzugten Ausführungsbeispiel der vorliegenden Erfindung ein Identifizierer (BccDataId) für jeden Parametersatz bereitgestellt. Dieser Identifizierer liefert Informationen über den Parametersatz-Typ, beispielsweise ICLD, ICTD oder ICC und/oder die Syntaxversion eines bestimmten Parametersatzes, wie es auch in Fig. 3b dargestellt ist. Üblicherweise wird der Identifizierer für unbedingt erforderliche Parametersätze implizit signalisiert, während der Identifizierer für optionale Parameter explizit signalisiert wird. In diesem Fall muss jedoch zwischen dem Codierer und dem Decodierer vereinbart sein, dass der beispielsweise erste Parametersatz, der angetroffen wird, der unbedingt erforderliche Parametersatz ist, welcher in dem fest vereinbarten Szenario z. B. Zwischenkanal-Pegeldifferenz-Parametersätze umfasst. Alternativ kann die Parametersatz-Typ-Information auch implizit durch Vorschreiben der Reihenfolge von Parametersatz-Typen definiert werden.

Parametersätze werden vorzugsweise Parametersatz-Längen-Informationen umfassen. Das Bereitstellen solcher Parametersatz-Längen-Informationen erlaubt es einem Decodierer, diesen Parametersatz zu ignorieren, indem die zugeordneten Bits einfach übergangen werden, ohne dass der Decodierer überhaupt nur die genaue Bitstromsyntax des Parametersatzes kennen muss. Zu diesem Zweck wird auf Fig. 4b verwiesen.

Bei dem bevorzugten Ausführungsbeispiel der vorliegenden Erfindung umfassen somit unbedingt erforderliche Parametersätze keine Parametersatzlängeninformationen, da der Decodierer die Daten über den unbedingt erforderlichen Parametersatz ohnehin auf jeden Fall analysieren (parsen) und verarbeiten muss, statt dass diese einfach verworfen werden könnten. So könnte ein Decodierer implementiert sein, um dann, wenn er einen Parametersatz aufspürt und keine zugeordneten weiteren Informationen enthält, davon auszugehen, dass der Parametersatz (beispielsweise ICLD) unter den bestimmten verfügbaren Parametersätzen ist, und dass dieser Parametersatz aufgrund der Tatsache, dass er keine entsprechende Information umfasst, ein unbedingt erforderlicher Parametersatz ist.

Für optionale Parametersätze können die ParametersatzLängeninformationen je nach Anwendungsfall übertragen oder nicht übertragen werden. Eine einfache Regel kann darin bestehen, dass zur Verbesserung der Interoperabilität zwischen Codierer und Decodierer alle optionalen Parametersätze Parametersatz-Längen-Informationen umfassen. Um jedoch Bits zu sparen, können für den letzten Parametersatz die Längeninformationen nicht übertragen werden, da kein Bedarf mehr besteht, diese Daten zu übergehen und auf einen nachfolgenden Parametersatz zuzugreifen, da der Parametersatz ohnehin schon der letzte Parametersatz ist. Dieses Prozedere ist natürlich dann sinnvoll, wenn ein Block von Daten, wie in Fig. 1a dann dargestellt ist, tatsächlich durch den i-ten Parametersatz 12c abgeschlossen wird, und nachfolgend nicht z. B. noch Steuerinformationen etc. für den gerade verarbeiteten Block des Summensignals bzw. der M Übertragungskanäle vorhanden sind.

Eine explizite Signalisierung könnte darin bestehen, dass z. B. gemäß den Ressourcen-Verfügbarkeitsinformationen 32 (Fig. 2b) die Übertragung von Parameterlängeninformationen dynamisch durch den Encodierer mittels eines Bitstromelements signalisiert werden kann, das die Anwesenheit/Länge der Parametersatzlängeninformationen einem Decodierer mitteilt, wie es bereits anhand von Fig. 3d dargestellt worden ist.

Nachfolgend wird auf ein bevorzugtes Ausführungsbeispiel für einen Decodierprozess eines durch einen in Fig. 2b gezeigten Decodierers eingegangen. Der bevorzugte Decodierer überprüft zunächst die Verfügbarkeit eines unbedingt erforderlichen (obligatorischen) Parametersatzes, der vorzugsweise der Zwischenkanal-Pegeldifferenzen-Parametersatz sein wird. Wenn ferner die Syntax-Versionsnummer des ILD-Parametersatzes höher als die Versionsnummer ist, die der Decodierer selbst decodieren kann, wobei der Decodierer z. B. Syntaxversionen von 1 bis n unterstützt, dann kann keine Rekonstruktion durch die Einrichtung 31 zum Rekonstruieren von Fig. 2b vorgenommen werden. In allen anderen Fällen kann eine bestimmte Form eines gültigen Decodierprozesses vorgenommen werden, indem der unbedingt erforderliche Parametersatz decodiert wird und dann, wenn keine optionalen Parametersätze verwendet werden, eine Multikanalsynthese nur unter Verwendung des unbedingt erforderlichen Parametersatzes durchgeführt wird.

Wenn ein Decodierer jedoch einen optionalen Parametersatz erfasst, kann er diesen verwenden, oder seinen Inhalt verwerfen. Welche der beiden Möglichkeiten genommen wird, hängt z. B. von dem nachfolgend dargelegten Szenario ab.

Wenn die Syntaxversionsnummer des optionalen Parametersatzes höher als die eingebaute Syntaxversionsfähigkeit des Decodierers selbst für diesen Parametersatztyp ist, dann kann dieser Parametersatztyp nicht durch den Decodierer verarbeitet werden und wird übergangen werden. In diesem Fall wird jedoch dennoch eine gültige Decodierung erreicht, ohne dass die verbesserte Multikanalrekonstruktion unter Verwendung des optionalen Parametersatztypen durchgeführt wird. Wenn allerdings der Inhalt des optionalen Parametersatzes, abhängig von den Fähigkeiten des Decodierers in Betracht gezogen werden kann, findet eine höherwertige Rekonstruktion statt.

Beispielsweise sei darauf hingewiesen, dass die Synthese unter Verwendung von Zwischenkanal-Kohärenzwerten eine beträchtliche Menge an Rechenressourcen in Anspruch nehmen kann. Somit kann ein Decodierer niedriger Komplexität z. B. abhängig von Ressourcensteuerungsinformationen diesen Parametersatz ignorieren, während ein Decodierer, der eine höhere Ausgabequalität liefern kann, sämtliche Parametersätze, also sowohl die unbedingt erforderlichen als auch die optionalen Parametersätze zur Rekonstruktion extrahieren und verwenden wird. Bei einem bevorzugten Ausführungsbeispiel wird die Entscheidung der Verwendung/Verwerfung eines Parametersatzes, basierend auf der Verfügbarkeit der Rechenressourcen zu einem entsprechenden Zeitpunkt, also dynamisch, vorgenommen.

Das erfindungsgemäße Konzept liefert die Möglichkeit der kompatiblen Aktualisierung des Bitstromformats für nicht unbedingt erforderliche, also optionale Parametersatztypen, ohne dass die Decodierbarkeit durch existierende Decodierer, also die Rückwärtskompatibilität durchbrochen wird. Ferner wird erfindungsgemäß auf jeden Fall sichergestellt, dass ältere Decodierer eine ungültige Ausgabe erzeugen werden, was im schlimmsten Fall sogar in einer Zerstörung der Lautsprecher resultieren könnte, wenn eine Aktualisierung der Syntax durch Erhöhen der Syntaxversionsnummer eines unbedingt erforderlichen Parametersatzes, also den ILD-Informationen vorgenommen wird, oder optional wie es beispielsweise durch das Feld "BccDataId" Nr.4 von Fig. 3b dargestellt ist.

Das erfindungsgemäße Konzept steht somit im Gegensatz zu einer klassischen Bitstromsyntax, bei der ein Decodierer die gesamte Syntax von jedem Parametersatz kennen muss, die in einem Bitstrom verwendet werden kann, um überhaupt zunächst alle Parametersätze einlesen zu können, um dann die entsprechenden Prozessorelemente, wie sie in Fig. 7 beispielsweise dargestellt sind, mit den entsprechenden Parametern ansteuern zu können. Ein erfindungsgemäßer Decodierer würde dann, wenn nur die Zwischenkanal-Pegeldifferenzen als unbedingt erforderlicher Parametersatz extrahiert worden sind, die Blöcke 126 und 128 übergehen, um eine, wenn auch geringer qualitative Multikanalrekonstruktion durchzuführen.

Zusammenfassend werden nachfolgend noch einmal die wesentlichen Merkmale des Codierers dargestellt, die vom Decodierer vorteilhaft verwendet werden können, um eine effiziente und hochqualitative Decodierung mit einem Datenstrom geringer Datenrate zu erreichen.

Ist ein Parametersatz bei der Rekonstruktion der K Ausgangskanäle im Hinblick auf eine Qualität eines rekonstruierten Multikanalsignals unwichtiger als ein anderer Parametersatz, so ist die Einrichtung 25 zum Schreiben ausgebildet, um den Datensatz so zu schreiben, dass eine Rekonstruktion ohne Verwendung des unwichtigeren Datensatzes möglich ist.

Vorzugsweise ist die Einrichtung 25 zum Schreiben ferner ausgebildet, um einen Parametersatz mit einem zugeordneten Identifizierer 100 bis 105 zu versehen, wobei ein Identifizierer für einen Parametersatz anzeigt, dass der Parametersatz für eine Rekonstruktion unbedingt verwendet werden muss, oder wobei ein Identifizierer für einen anderen Parametersatz anzeigt, dass der Parametersatz für eine Rekonstruktion nur optional verwendet werden kann.

Vorzugsweise ist die Einrichtung 25 zum Schreiben ferner ausgebildet, um die M Übertragungskanäle in einen Übertragungskanalabschnitt 11 des Datensatzes des Datenstroms zu schreiben, um einen ersten Parametersatz in einen ersten Parametersatzabschnitt 12a, und um einen zweiten Parametersatz in einen zweiten Parametersatzabschnitt 12b so zu schreiben, dass ein Decodierer die K Ausgangskanäle rekonstruieren kann, ohne den zweiten Parametersatzabschnitt (12b) zu lesen und zu interpretieren.

Falls die Parametersätze aus folgender Gruppe ausgewählt sind, die Zwischenkanal-Pegeldifferenzen, Zwischenkanal-Zeitdifferenzen, Zwischenkanal-Phasendifferenzen oder Zwischenkanal-Kohärenzinformationen umfasst, so ist die Einrichtung 25 zum Schreiben ausgebildet, um den Parametersatz Zwischenkanal-Pegeldifferenzen als zur Decodierung unbedingt nötig zu kennzeichnen, und um wenigstens einen anderen Parametersatz der Gruppe als für die Decodierung optional zu kennzeichnen.

Vorzugsweise ist die Einrichtung 25 zum Schreiben ausgebildet, um den zweiten Parametersatz mit Längeninformationen 106 bis 108 zu versehen, die anzeigen, welche Menge an Daten im Datensatz zu dem zweiten Parametersatz gehört, so dass ein Decodierer in der Lage ist, die Menge an Daten aufgrund der Längeninformation zu überspringen, wobei die Längeninformationen vorzugsweise ein erstes Feld zum Signalisieren einer Länge in Bits eines Längenfeldes aufweisen, und wobei das Längenfeld die Länge in Bits aufweist, durch die eine Menge an Bits des zweiten Parametersatzes angegeben ist.

Vorzugsweise ist die Einrichtung 25 zum Schreiben ferner ausgebildet, um eine Anzahlinformation 102 in den Datenstrom zu schreiben, die eine Anzahl von optionalen Parametersätzen anzeigt, ohne die eine Rekonstruktion der K Ausgangskanäle durch den Decodierer erfolgen kann. Vorzugsweise ist die Einrichtung 25 zum Schreiben ferner ausgebildet, um den Parametersätzen Syntaxversionsinformationen 103 bis 105 zuzuordnen, so dass ein Decodierer nur dann, wenn eine Syntaxversionsinformation einen vorbestimmten Zustand hat, eine Rekonstruktion unter Verwendung des entsprechenden Parametersatzes durchführt.

Vorzugsweise liegen ferner lediglich für den zweiten Parametersatz und ggf. weitere optionale Parametersätze Syntaxversionsinformationen vor.

Außerdem kann ein letzter optionaler Parametersatz in einer Folge von Parametersätzen in dem Datenstrom keine zugeordneten Längeninformationen aufweisen.

Ferner kann die Einrichtung 25 zum Schreiben ausgebildet sein, um eine Anwesenheit und Länge von ParametersatzLängeninformationen dynamisch in dem Datenstrom zu signalisieren.

Die Einrichtung 22 zum Bereitstellen kann ausgebildet sein, um für die M Übertragungskanäle eine Folge von Datenblöcken zu liefern, die auf eine Folge von Blöcken von zeitlichen Abtastwerten zumindest eines Ursprungskanals zurückgeht.

Abhängig von den Gegebenheiten kann das erfindungsgemäße Verfahren zum Erzeugen bzw. Decodieren in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass das Verfahren ausgeführt wird. Allgemein besteht die Erfindung somit auch in einem Computer-Programm-Produkt mit einem auf einem maschinenlesbaren Träger gespeicherten Programmcode zur Durchführung des Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

## Patentansprüche

1. Vorrichtung zum Erzeugen eines codierten Multikanalsignals, das ein uncodiertes Multikanalsignal darstellt, das N Ursprungskanäle aufweist, wobei N größer oder gleich 2 ist, mit folgenden Merkmalen:
einer Einrichtung (22) zum Bereitstellen von Parameterinformationen (24a,24b,24c) zum Rekonstruieren von K Ausgangskanälen aus M Übertragungskanälen (23), wobei M größer oder gleich 1 ist und kleiner oder gleich N ist, wobei K größer als M und kleiner oder gleich N ist, wobei die Parameterinformationen wenigstens einen ersten Parametersatz und einen unterschiedlichen zweiten Parametersatz zum Rekonstruieren ein und desselben Ausgangskanals aufweisen, wobei der zweite Parametersatz zugeordnete Syntaxversionsinformationen (103 bis 105) aufweist; und
einer Einrichtung (25) zum Schreiben eines Datenstroms (26), wobei die Einrichtung (25) zum Schreiben ausgebildet ist, um den ersten und den zweiten Parametersatz so in den Datenstrom zu schreiben, dass eine Rekonstruktion von wenigstens einem der K Ausgangskanäle unter Verwendung des ersten Parametersatzes, ohne Verwendung des zweiten Parametersatzes und unter Verwendung wenigstens eines der M Übertragungskanäle (23) in einem Decodierer durchführbar ist,
wobei die Einrichtung (25) zum Schreiben ausgebildet ist, um Längeninformationen, die eine Menge von Daten des zugeordneten zweiten Parametersatzes anzeigen, in den Datenstrom zu schreiben.

2. Vorrichtung zum Decodieren eines codierten Multikanalsignals, das ein uncodiertes Multikanalsignal darstellt, das N Ursprungskanäle aufweist, wobei das codierte Multikanalsignal durch einen Datenstrom dargestellt ist, der Parameterinformationen zum Rekonstruieren von K Ausgangskanälen aus M Übertragungskanälen aufweist, wobei M größer oder gleich 1 ist und kleiner oder gleich N ist, wobei K größer als M und kleiner oder gleich N ist, wobei die Parameterinformationen wenigstens zwei unterschiedliche Parametersätze zum Rekonstruieren von ein- und demselben Ausgangskanal aufweisen, und wobei der erste und der zweite Parametersatz so in den Datenstrom geschrieben sind, dass eine Rekonstruktion der K Ausgangskanäle unter Verwendung des ersten Parametersatzes und ohne Verwendung des zweiten Parametersatzes in einem Decodierer durchführbar ist, wobei der zweite Parametersatz zugeordnete Syntaxversionsinformationen (103 bis 105) aufweist, mit folgendem Merkmal:
einer Datenstrom-Leseeinrichtung (28) zum Lesen des Datenstroms, um den ersten Parametersatz einzulesen (30a), und um den zweiten Parametersatz dann zu übergehen (30b), wenn die dem zweiten Parametersatz zugeordneten Syntaxversionsinformationen mit einer vorgegebenen Syntaxversionsinformation der Vorrichtung zum Decodieren nicht kompatibel sind, und um den zweiten Parametersatz einzulesen, wenn die Syntaxversionsinformationen mit der vorgegebenen Syntaxversionsinformation kompatibel ist,
wobei der zweite Parametersatz Längeninformationen aufweist, die eine Menge von Daten des zugeordneten zweiten Parametersatzes anzeigen, und wobei die Leseeinrichtung (28) ausgebildet ist, um im Datenstrom aufgrund der Längeninformationen eine Menge von Daten zu übergehen, die durch die Längeninformation angezeigt wird, ohne die Daten des zweiten Parametersatzes syntaktisch zu analysieren.

3. Vorrichtung nach Anspruch 2, die ferner folgendes Merkmal aufweist:
eine Rekonstruktionseinrichtung (32) zum Rekonstruieren der K Ausgangskanäle unter Verwendung der M Übertragungskanäle und des ersten Parametersatzes, nicht aber unter Verwendung des zweiten Parametersatzes.

4. Vorrichtung nach Anspruch 2 oder 3, bei der der erste Parametersatz eine zugeordnete Syntaxversionsinformation (103 bis 105) aufweist, und
bei der die Leseeinrichtung (28) ausgebildet ist, um die zugeordnete Syntaxversionsinformation zu lesen und die Rekonstruktionseinrichtung (31) so zu steuern, dass eine Rekonstruktion durch die Rekonstruktionseinrichtung nur durchgeführt wird, wenn die gelesenen Syntaxversionsinformationen mit einer vorgegebenen Syntaxversionsinformation der Vorrichtung zum Decodieren kompatibel sind.

5. Vorrichtung nach einem der Ansprüche 2 bis 4, bei der die Leseeinrichtung (28) steuerbar ist (32), um Ressourcenverfügbarkeitsinformationen zu erhalten, und
bei der die Leseeinrichtung (28) ferner ausgebildet ist, um dann, wenn die Ressourcenverfügbarkeitsinformationen ausreichend Ressourcen anzeigen, den zweiten Parametersatz einzulesen, und um dann, wenn die Ressourcenverfügbarkeitsinformationen nicht ausreichende Ressourcen anzeigen, den zweiten Parametersatz zu übergehen.

6. Vorrichtung nach einem der Ansprüche 2 bis 5, bei der ein Parametersatz bei der Rekonstruktion der K Ausgangskanäle im Hinblick auf eine Qualität eines rekonstruierten Multikanalsignals unwichtiger als ein anderer Parametersatz ist, und bei der die Datenstrom-Leseeinrichtung (28) ausgebildet ist, um den unwichtigeren Datensatz zu übergehen.

7. Vorrichtung nach einem der Ansprüche 2 bis 6, bei der der Datenstrom einen Parametersatz mit einem zugeordneten Identifizierer (100 bis 105) aufweist, wobei ein Identifizierer für einen Parametersatz anzeigt, dass der Parametersatz für eine Rekonstruktion unbedingt verwendet werden muss, oder wobei ein Identifizierer für einen anderen Parametersatz anzeigt, dass der Parametersatz für eine Rekonstruktion nur optional verwendet werden kann, wobei die Datenstrom-Leseeinrichtung (28) ausgebildet ist, um den Identifizierer zu erfassen und aufgrund des erfassten Identifizierers den unbedingt erforderlichen Parametersatz zu lesen und einen optionalen Parametersatz zu übergehen.

8. Vorrichtung nach einem der Ansprüche 2 bis 7, bei der der Datenstrom einen ersten Parametersatz in einem ersten Parametersatzabschnitt (12a) und einen zweiten Parametersatz in einem zweiten Parametersatzabschnitt (12b) aufweist, wobei die Datenstrom-Leseeinrichtung ausgebildet ist, den Datenstrom im Hinblick auf die Parametersatzabschnitte zu interpretieren und den ersten Parametersatzabschnitt einzulesen und den zweiten Parametersatzabschnitt zu übergehen.

9. Vorrichtung nach einem der Ansprüche 2 bis 8, bei der Parametersätze aus folgender Gruppe ausgewählt sind, die Zwischenkanal-Pegeldifferenzen, Zwischenkanal-Zeitdifferenzen, Zwischenkanal-Phasendifferenzen oder Zwischenkanal-Kohärenzinformationen umfasst, wobei in dem Datenstrom der Parametersatz Zwischenkanal-Pegeldifferenzen als zur Decodierung unbedingt nötig gekennzeichnet ist, und wobei wenigstens ein anderer Parametersatz der Gruppe als für die Decodierung optional gekennzeichnet ist, und wobei die Datenstrom-Leseeinrichtung (28) ausgebildet ist, um den Parametersatz Zwischenkanal-Pegeldifferenzen einzulesen und einen anderen Parametersatz aus der Gruppe zu übergehen.

10. Vorrichtung nach einem der Ansprüche 2 bis 9, bei der der Datenstrom eine Anzahlinformation (102) aufweist, die eine Anzahl von optionalen Parametersätzen anzeigt, ohne die eine Rekonstruktion der K Ausgangskanäle durch den Decodierer erfolgen kann, wobei die Datenstrom-Leseeinrichtung ausgebildet ist, um aufgrund der Anzahlinformation wenigstens einen optionalen Parametersatz einzulesen.

11. Vorrichtung nach Anspruch 2, bei der für den zweiten Parametersatz und ggf. weitere optionale Parametersätze zugeordnete Syntaxversionsinformationen im Datenstrom vorliegen, wobei für den ersten Parametersatz keine Syntaxversionsinformationen vorliegen.

12. Vorrichtung nach einem der vorhergehenden Ansprüche, bei der ein letzter optionaler Parametersatz in einer Folge von Parametersätzen in dem Datenstrom keine zugeordneten Längeninformationen aufweist, wobei die Datenstrom-Leseeinrichtung (28) ausgebildet ist, um vor dem Einlesen des letzten optionalen Parametersatzes keine Längeninformationen zu lesen und zu interpretieren.

13. Vorrichtung nach einem der Ansprüche 2 bis 12, bei der eine Anwesenheit und Länge von ParametersatzLängeninformationen dynamisch in dem Datenstrom signalisiert sind, und bei dem die Datenstrom-Leseeinrichtung (28) ausgebildet ist, um zunächst im Datenstrom die Anwesenheit von ParametersatzLängeninformationen zu erfassen, um dann, aufgrund einer erfassten Anwesenheit die Länge der ParametersatzLängeninformationen aus dem Datenstrom zu extrahieren.

14. Vorrichtung nach einem der Ansprüche 3 bis 13, bei der die M Übertragungskanäle BCC-Downmix-Kanäle sind und die Parametersätze BCC-Parameter umfassen, und bei der die Rekonstruktionseinrichtung (32) ausgebildet ist, um eine BCC-Synthese durchzuführen.

15. Verfahren zum Erzeugen eines codierten Multikanalsignals, das ein uncodiertes Multikanalsignal darstellt, das N Ursprungskanäle aufweist, wobei N größer oder gleich 2 ist, mit folgenden Schritten:
Bereitstellen (22) von Parameterinformationen (24a, 24b, 24c) zum Rekonstruieren von K Ausgangskanälen aus M Übertragungskanälen (23), wobei M größer gleich 1 ist und kleiner oder gleich N ist, wobei K größer als M und kleiner oder gleich N ist, wobei die Parameterinformationen wenigstens zwei unterschiedliche Parametersätze zum Rekonstruieren ein und desselben Ausgangskanals aufweisen; und
Schreiben (25) eines Datenstroms (26) durch Schreiben des ersten und des zweiten Parametersatzes so in den Datenstrom, dass eine Rekonstruktion von wenigstens einem der K Ausgangskanäle unter Verwendung des ersten Parametersatzes, ohne Verwendung des zweiten Parametersatzes und unter Verwendung von wenigstens einem der M Übertragungskanäle (23) in einem Decodierer durchführbar ist, wobei der zweite Parametersatz zugeordnete Syntaxversionsinformationen (103 bis 105) aufweist,
wobei beim Schreiben (25) Längeninformationen, die eine Menge von Daten des zugeordneten zweiten Parametersatzes anzeigen, in den Datenstrom geschrieben werden.

16. Verfahren zum Decodieren eines codierten Multikanalsignals, das ein uncodiertes Multikanalsignal darstellt, das N Ursprungskanäle aufweist, wobei das codierte Multikanalsignal durch eine Datenstrom dargestellt ist, der Parameterinformationen zum Rekonstruieren von K Ausgangskanälen aus M Übertragungskanälen aufweist, wobei M größer oder gleich 1 ist und kleiner oder gleich N ist, wobei K größer als M und kleiner oder gleich N ist, wobei die Parameterinformationen wenigstens zwei unterschiedliche Parametersätze zum Rekonstruieren von ein- und demselben Ausgangskanal aufweisen, und wobei der erste und der zweite Parametersatz so in den Datenstrom geschrieben sind, dass eine Rekonstruktion der K Ausgangskanäle unter Verwendung des ersten Parametersatzes und ohne Verwendung des zweiten Parametersatzes in einem Decodierer durchführbar ist, wobei der zweite Parametersatz zugeordnete Syntaxversionsinformationen (103 bis 105) aufweist, mit folgendem Schritt:
Lesen (28) des Datenstroms, um den ersten Parametersatz einzulesen (30a), und um den zweiten Parametersatz dann zu übergehen (30b), wenn die dem zweiten Parametersatz zugeordneten Syntaxversionsinformationen mit einer vorgegebenen Syntaxversionsinformation der Vorrichtung zum Decodieren nicht kompatibel sind, und um den zweiten Parametersatz einzulesen, wenn die Syntaxversionsinformationen mit der vorgegebenen Syntaxversionsinformation kompatibel ist,
wobei der zweite Parametersatz Längeninformationen aufweist, die eine Menge von Daten des zugeordneten zweiten Parametersatzes anzeigen, und wobei beim Lesen (28) im Datenstrom aufgrund der Längeninformationen eine Menge von Daten übergangen wird, die durch die Längeninformation angezeigt wird, ohne dass die Daten des zweiten Parametersatzes syntaktisch analysiert werden.

17. Computer-Programm mit einem Programmcode zum Durchführen des Verfahrens gemäß Patentanspruch 15 oder 16, wenn das Computer-Programm auf einem Rechner abläuft.

## Claims

1. Device for generating a coded multi-channel signal representing an uncoded multi-channel signal comprising N original channels, wherein N is equal to or larger than 2, comprising:
means (22) for providing parameter information (24a, 24b, 24c) for reconstructing K output channels from M transmission channels (23), wherein M is equal to or larger than 1 and equal to or less than N, wherein K is larger than M and equal to or less than N, wherein the parameter information comprises at least one first parameter set and a different second parameter set for reconstructing one and the same output channel, wherein the second parameter set comprises associated syntax version information (103 to 105); and
means (25) for writing a data stream (26), wherein the means (25) for writing is designed to write the first and the second parameter sets into the data stream so that a reconstruction of at least one of the K output channels may be performed in a decoder using the first parameter set, without using the second parameter set and using at least one of the M transmission channels (23),
wherein the means (25) for writing is designed to write length information indicating an amount of data of the associated second parameter set into the data stream.

2. Device for decoding a coded multi-channel signal representing an uncoded multi-channel signal comprising N original channels, wherein the coded multi-channel signal is represented by a data stream comprising parameter information for reconstructing K output channels from M transmission channels, wherein M is equal to or larger than 1 and equal to or less than N, wherein K is larger than M and equal to or less than N, wherein the parameter information comprises at least two different parameter sets for reconstructing one and the same output channel, and wherein the first and the second parameter sets are written into the data stream so that a reconstruction of the K output channels may be performed in a decoder using the first parameter set and without using the second parameter set, wherein the second parameter set comprises associated syntax version information (103 to 105), comprising:
data stream reading means (28) for reading the data stream to read in the first parameter set (30a) and to skip the second parameter set (30b) when the syntax version information associated with the second parameter set is not compatible with given syntax version information of the device for decoding, and to read in the second parameter set when the syntax version information is compatible with the given syntax version information,
wherein the second parameter set comprises length information indicating an amount of data of the associated second parameter set, and wherein the reading means (28) is designed to skip an amount of data in the data set indicated by the length information based on the length information without parsing the data of the second parameter set.

3. Device according to claim 2, further comprising:
reconstruction means (32) for reconstructing the K output channels using the M transmission channels and the first parameter set, but not using the second parameter set.

4. Device according to claim 2 or 3, wherein the first parameter set comprises associated syntax version information (103 to 105), and
wherein the reading means (28) is designed to read the associated syntax version information and to drive the reconstruction means (31) so that a reconstruction is performed by the reconstruction means only when the read syntax version information is compatible with given syntax version information of the device for decoding.

5. Device according to one of the claims 2 to 4, wherein the reading means (28) is controllable (32) to obtain resource availability information, and
wherein the reading means (28) is further designed to read in the second parameter set when the resource availability information indicates sufficient resources, and to skip the second parameter set when the resource availability information indicates insufficient resources.

6. Device according to one of claims 2 to 5, wherein one parameter set is less important than another parameter set in the reconstruction of the K output channels with respect to a quality of a reconstructed multi-channel signal, and wherein the data stream reading means (28) is designed to skip the less important data set.

7. Device according to one of claims 2 to 6, wherein the data stream comprises a parameter set with an associated identifier (100 to 105), wherein an identifier for a parameter set indicates that the parameter set absolutely has to be used for a reconstruction, or wherein an identifier for another parameter set indicates that the parameter set may only be used optionally for a reconstruction, wherein the data stream reading means (28) is designed to detect the identifier and to read the mandatory parameter set and to skip an optional parameter set based on the detected identifier.

8. Device according to one of claims 2 to 7, wherein the data stream comprises a first parameter set in a first parameter set portion (12a) and a second parameter set in a second parameter set portion (12b), wherein the data stream reading means is designed to interpret the data stream with respect to the parameter set portions and to read in the first parameter set portion and to skip the second parameter set portion.

9. Device according to one of claims 2 to 8, wherein parameter sets are selected from the following group including inter-channel level differences, interchannel time differences, inter-channel phase differences or inter-channel coherence information, wherein, in the data stream, the inter-channel level differences parameter set is marked as absolutely required for decoding, and wherein at least one other parameter set of the group is marked as optional for the decoding, and wherein the data stream reading means (28) is designed to read in the inter-channel level differences parameter set and to skip another parameter set from the group.

10. Device according to one of claims 2 to 9, wherein the data stream comprises number information (102) indicating a number of optional parameter sets without which a reconstruction of the K output channels may be done by the decoder, wherein the data stream reading means is designed to read in at least one optional parameter set based on the number information.

11. Device according to claim 2, wherein there is associated syntax version information in the data stream for the second parameter set and further optional parameter sets, if applicable, wherein there is no syntax version information for the first parameter set.

12. Device according to one of the preceding claims, wherein a last optional parameter set in a sequence of parameter sets in the data stream does not comprise any associated length information, wherein the data stream reading means (28) is designed not to read and interpret any length information prior to reading in the last optional parameter set.

13. Device according to one of claims 2 to 12, wherein presence and length of parameter set length information are signaled dynamically in the data stream, and wherein the data stream reading means (28) is designed to detect first the presence of parameter set length information in the data stream to then extract the length of the parameter set length information from the data stream based on a detected presence.

14. Device according to one of claims 3 to 13, wherein the M transmission channels are BCC downmix channels and the parameter sets include BCC parameters, and wherein the reconstruction means (32) is designed to perform a BCC synthesis.

15. Method for generating a coded multi-channel signal representing an uncoded multi-channel signal comprising N original channels, wherein N is equal to or larger than 2, comprising:
providing (22) parameter information (24a, 24b, 24c) for reconstructing K output channels from M transmission channels (23), wherein M is equal to or larger than 1 and equal to or less than N, wherein K is larger than M and equal to or less than N, wherein the parameter information comprises at least two different parameter sets for reconstructing one and the same output channel; and
writing (25) a data stream (26) by writing the first and the second parameter sets into the data stream so that a reconstruction of at least one of the K output channels may be done using the first parameter set, without using the second parameter set and using at least one of the M transmission channels (23), wherein the second parameter set comprises associated syntax version information (103 to 105),
wherein during writing (25) length information indicating an amount of data of the associated second parameter set is written into the data stream.

16. Method for decoding a coded multi-channel signal representing an uncoded multi-channel signal comprising N original channels, wherein the coded multi-channel signal is represented by a data stream comprising parameter information for reconstructing K output channels from M transmission channels, wherein M is equal to or larger than 1 and equal to or less than N, wherein K is larger than M and equal to or less than N, wherein the parameter information comprises at least two different parameter sets for reconstructing one and the same output channel, and wherein the first and the second parameter sets are written into the data stream so that a reconstruction of the K output channels may be performed in a decoder using the first parameter set and without using the second parameter set, wherein the second parameter set comprises associated syntax version information (103 to 105), comprising:
reading (28) the data stream to read in the first parameter set (30a) and to skip the second parameter set (30b) when the syntax version information associated with the second parameter set is not compatible with given syntax version information of the device for decoding, and to read in the second parameter set when the syntax version information is compatible with the given syntax version information,
wherein the second parameter set comprises length information indicating an amount of data of the associated second parameter set, and wherein the reading means (28) is designed to skip an amount of data in the data set indicated by the length information based on the length information without parsing the data of the second parameter set.

17. Computer program having a program code for performing the method according to claim 15 or 16, when the computer program runs on a computer.

## Revendications

1. Appareil pour générer un signal multicanal codé représentant un signal multicanal non codé présentant N canaux originaux, où N est supérieur ou égal à 2, aux caractéristiques suivantes:
un moyen (22) destiné à mettre à disposition des informations de paramètre (24a, 24b, 24c) pour reconstruire K canaux de sortie à partir de M canaux de transmission (23), où M est supérieur ou égal à 1 et inférieur ou égal à N, où K est supérieur à M et inférieur ou égal à N, les informations de paramètre présentant au moins un premier ensemble de paramètres et un deuxième ensemble de paramètres différent pour reconstruire un même canal de sortie, le deuxième ensemble de paramètres présentant des informations de version de syntaxe associées (103 à 105), et
un moyen (25) destiné à écrire un flux de données (26), le moyen pour écrire (25) étant conçu pour écrire le premier et le deuxième ensemble de paramètres dans le flux de données de sorte qu'une reconstitution d'au moins l'un des K canaux de sortie puisse être mis en oeuvre dans un décodeur à l'aide du premier ensemble de paramètres, sans utiliser le deuxième ensemble de paramètres et à l'aide d'au moins l'un des M canaux de transmission (23),
dans lequel le moyen pour écrire (25) est conçu pour écrire dans le flux de données des informations de longueur indiquant une quantité e données du deuxième ensemble de paramètres associé.

2. Appareil pour décoder un signal multicanal codé représentant un signal multicanal non codé présentant N canaux originaux, dans lequel le signal multicanal codé est représenté par un flux de données présentant des informations de paramètre pour reconstruire K canaux de sortie à partir de M canaux de transmission, où M est supérieur ou égal à 1 et inférieur ou égal à N, où K est supérieur à M et inférieur ou égal à N, dans lequel les informations de paramètre comprennent au moins deux ensembles de paramètres différents pour la reconstruction d'un même canal de sortie, et dans lequel le premier et le deuxième ensemble de paramètres sont écrits dans le flux de données qu'une reconstruction des K canaux de sortie puisse être réalisée dans un décodeur à l'aide du premier ensemble de paramètres et sans utilisation du deuxième ensemble de paramètres, dans lequel le deuxième ensemble de paramètres présente des informations de version de syntaxe (103 à 105) associées, à la caractéristique suivante:
un moyen de lecture de flux de données (28) pour lire le flux de données, pour lire le premier ensemble de paramètres (30a) et pour sauter le deuxième ensemble de paramètres (30b) lorsque les informations de version de syntaxe associées au deuxième ensemble de paramètres ne sont pas compatibles avec une information de version de syntaxe prédéterminée du dispositif de décodage, et pour lire le deuxième ensemble de paramètres lorsque les informations de version de syntaxe sont compatibles avec l'information de version de syntaxe prédéterminée,
dans lequel le deuxième ensemble de paramètres présente des informations de longueur indiquant une quantité de données du deuxième ensemble de paramètres associé, et dans lequel le moyen de lecture (28) est conçu pour sauter dans le flux de données, sur base des informations de longueur, une quantité de données indiquée par l'information de longueur, sans analyser de manière syntaxique les données du deuxième ensemble de paramètres.

3. Dispositif selon la revendication 2, présentant par ailleurs la caractéristique suivante:
un moyen de reconstruction (32) pour reconstruire les K canaux de sortie à l'aide des M canaux de transmission et du premier ensemble de paramètres, mais pas à l'aide du deuxième ensemble de paramètres.

4. Dispositif selon la revendication 2 ou 3, dans lequel le premier ensemble de paramètres présente une information de version de syntaxe associée (103 à 105), et
dans lequel le moyen de lecture (28) est conçu pour lire l'information de version syntaxe associée et pour commander le moyen de reconstruction (31) de sorte qu'une reconstruction par le moyen de reconstruction ne soit effectuée que lorsque les informations de version de syntaxe lues sont compatibles avec une information de version de syntaxe prédéterminée du dispositif de décodage.

5. Dispositif selon l'une des revendications 2 à 4, dans lequel le moyen de lecture (28) peut être commandé (32) pour obtenir des informations de disponibilité de ressources, et
dans lequel le moyen de lecture (28) est par ailleurs conçu pour lire, lorsque les informations de disponibilité de ressources indiquent suffisamment de ressources, le deuxième ensemble de paramètres et pour sauter, lorsque les informations de disponibilité de ressources n'indiquent pas suffisamment de ressources, le deuxième ensemble de paramètres.

6. Dispositif selon l'une des revendications 2 à 5, dans lequel un ensemble de paramètres est, lors de la reconstruction des K canaux de sortie, moins important en ce qui concerne une qualité d'un signal multicanal reconstruit qu'un autre ensemble de paramètres, et dans lequel le moyen de lecture de flux de données (28) est conçu pour sauter l'ensemble de paramètres moins important.

7. Dispositif selon l'une des revendications 2 à 6, dans lequel le flux de données présente un ensemble de paramètres avec un identificateur associé (100 à 105), un identificateur indiquant pour un ensemble de paramètres que l'ensemble de paramètres doit absolument être utilisé pour la reconstruction, ou un identificateur indiquant pour un autre ensemble de paramètres que le paramètre ne peut être utilisé que de manière optionnelle pour une reconstruction, dans lequel le dispositif de lecture de flux de données (28) est conçu pour capturer l'identificateur et pour lire, sur base de l'identificateur saisi, l'ensemble de paramètres absolument nécessaire et pour sauter un ensemble de paramètres optionnel.

8. Dispositif selon l'une des revendications 2 à 7, dans lequel le flux de données présente un premier ensemble de paramètres dans un premier segment d'ensemble de paramètres (12a) et un deuxième ensemble de paramètres dans un deuxième segment d'ensemble de paramètres (12b), dans lequel le moyen de lecture de flux de données est conçu pour interpréter le flux de données en ce qui concerne les segments d'ensemble de paramètres et pour lire le premier segment d'ensemble de paramètres et sauter le deuxième segment d'ensemble de paramètres.

9. Dispositif selon l'une des revendications 2 à 8, dans lequel les ensembles de paramètres sont sélectionnés parmi le groupe suivant qui comprend les différences de niveau entre canaux, les différences de temps entre canaux, les différences de phase entre canaux ou les informations de cohérence entre canaux, dans lequel l'ensemble de paramètres de différences de niveau entre canaux est caractérisé dans le flux de données comme absolument nécessaire pour le décodage, et dans lequel au moins un autre ensemble de paramètres du groupe est caractérisé de manière optionnelle pour le décodage, et dans lequel le moyen de lecture de flux de données (28) est conçu pour lire l'ensemble de paramètres de différences de niveau entre canaux et pour sauter un autre ensemble de paramètres du groupe.

10. Dispositif selon l'une des revendications 2 à 9, dans lequel le flux de données présente une information de nombre (102) indiquant un nombre d'ensembles de paramètres optionnels sans lesquels peut avoir lieu par le décodeur une reconstruction des K canaux de sortie, le moyen de lecture de flux de données étant conçu pour lire, sur base de l'information de nombre, au moins un ensemble de paramètres optionnel.

11. Dispositif selon la revendication 2, dans lequel sont présentes dans le flux de données, pour le deuxième ensemble de paramètres et éventuellement d'autres ensembles de paramètres optionnels, les informations de version de syntaxe associées, pour le premier ensemble de paramètres n'étant pas présentes d'informations de version de syntaxe.

12. Dispositif selon l'une des revendications précédentes, dans lequel un dernier ensemble de paramètres optionnel dans une séquence d'ensembles de paramètres dans le flux de données ne présente pas d'informations de longueur associées, dans lequel le moyen de lecture de flux de données (28) est conçu pour ne pas lire et interpréter d'informations de longueur avant de lire le dernier ensemble de paramètres optionnel.

13. Dispositif selon l'une des revendications 2 à 12, dans lequel une présence et une longueur des informations d'ensembles de paramètres sont signalées dynamiquement dans le flux de données, et dans lequel le moyen de lecture de flux de données (28) est conçu pour détecter tout d'abord dans le flux de données la présence d'informations de longueur d'ensembles de paramètres, et pour extraire ensuite du flux de données, sur base d'une présence détectée, la longueur des informations de longueur d'ensembles de paramètres.

14. Dispositif selon l'une des revendications 3 à 13, dans lequel les M canaux de transmission sont des canaux de mélange descendant BCC et les ensembles de paramètres comprennent des paramètres BCC, et dans lequel le moyen de reconstruction (32) est conçu pour effectuer une synthèse BCC.

15. Procédé pour générer un signal multicanal codé représentant un signal multicanal non codé présentant N canaux originaux, où N est supérieur ou égal à 2, aux étapes suivantes consistant à:
mettre à disposition (22) des informations de paramètres (24a, 24b, 24c) pour reconstruire K canaux de sortie à partir de M canaux de transmission (23), où M est supérieur ou égal à 1 et inférieur ou égal à N, où K est supérieur à M et inférieur ou égal à N, où les informations de paramètres présentent au moins deux ensembles de paramètres différents pour reconstruire un même canal de sortie; et
écriture (25) un flux de données (26) en écrivant le premier et le deuxième ensemble de paramètres dans les flux de données de sorte qu'une reconstitution d'au moins l'un des K canaux de sortie puisse être réalisée dans un décodeur à l'aide du premier ensemble de paramètres, sans utiliser les deuxième ensemble de paramètres et à l'aide d'au moins l'un des M canaux de transmission (23), dans lequel le deuxième ensemble de paramètres présente à des informations de version de syntaxe (103 à 105) associées,
dans lequel, lors de l'écriture (25), des informations de longueur indiquant une quantité de données du deuxième ensemble de paramètres associé, sont écrites dans le flux de données.

16. Procédé de décodage d'un signal multicanal codé représentant un signal multicanal non codé présentant N canaux originaux, dans lequel le signal multicanal codé est représenté par un flux de données présentant des informations de paramètres pour la reconstruction de K canaux de sortie à partir de M canaux de transmission, où M est supérieur ou égal à 1 et inférieur ou égal à N, où K est supérieur à M et inférieur ou égal à N, dans lequel les informations de paramètres présentent au moins deux ensembles de paramètres différents pour reconstruire un même canal de sortie, et dans lequel le premier et le deuxième ensemble de paramètres sont écrits dans le flux de données de sorte que soit réalisée dans un décodeur une reconstruction des K canaux de sortie à l'aide du premier ensemble de paramètres et sans utilisation du deuxième ensemble de paramètres, dans lequel le deuxième ensemble de paramètres présente des informations de version de syntaxe (103 à 105) associées, à l'étape suivante consistant à :
lire (28) le flux de données pour lire le premier ensemble de paramètres (30a) et pour sauter le deuxième ensemble de paramètres (30b) lorsque les informations de version de syntaxe associées au deuxième ensemble de paramètres ne sont pas compatibles avec une information de version de syntaxe prédéterminée du dispositif de décodage et pour lire le deuxième ensemble de paramètres lorsque les informations de version de syntaxe sont compatibles avec l'information de version de syntaxe prédéterminée,
dans lequel le deuxième ensemble de paramètres présente des informations de longueur indiquant une quantité de données du deuxième ensemble de paramètres associé, et dans lequel lors de la lecture (28) est sautée dans le flux de données, sur base des informations de longueur, une quantité de données indiquée par l'information de longueur, sans que les données du deuxième ensemble de paramètres ne soient analysés de manière syntaxique.

17. Programme d'ordinateur avec un code de programme pour réaliser le procédé selon la revendication 15 ou 16 lorsque le programme d'ordinateur est exécuté sur un ordinateur.
